Europäisches Patentamt

European Patent Office

Office européen des brevets

(11) Publication number: **0 178 948 B1**

# EUROPEAN PATENT SPECIFICATION

(45) Date of publication of patent specification: **27.12.91**    (51) Int. Cl.⁵: **G06F 11/20**

(21) Application number: **85307560.4**

(22) Date of filing: **18.10.85**

(54) Bipolar-transistor random access memory having a redundancy configuration.

(30) Priority: **19.10.84 JP 218707/84**
**20.11.84 JP 243340/84**

(43) Date of publication of application:
**23.04.86 Bulletin 86/17**

(45) Publication of the grant of the patent:
**27.12.91 Bulletin 91/52**

(84) Designated Contracting States:
**DE FR GB**

(56) References cited:
**EP-A- 0 087 610**
**US-A- 3 693 159**

(73) Proprietor: **FUJITSU LIMITED**
**1015, Kamikodanaka Nakahara-ku**
**Kawasaki-shi Kanagawa 211(JP)**

(72) Inventor: **Okajima, Yoshinori**
**Fukuju-so 7 5-10-7, Miyazaki Miyamae-ku**
**Kawasaki-shi Kanagawa 213(JP)**

(74) Representative: **Skone James, Robert Edmund**
**et al**
**GILL JENNINGS & EVERY 53-64 Chancery**
**Lane**
**London WC2A 1HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a bipolar-transistor type random access memory (RAM) having a redundancy configuration and, more particularly, to a defective address memory portion thereof.

In a RAM device, a large number of memory cells are arranged along rows and columns. The density of defects generated in such a semiconductor memory device during the manufacture thereof is relatively independent of the integration density of the device. Rather, it derives from the semiconductor manufacturing technology. In general, the higher the integration density of the device, the greater the ratio of normal memory cells to defective memory cells. This is one of the advantages of increasing the integration density of a semiconductor memory device.

Even if a device includes only one defective memory cell, however, the device cannot be operated normally and, therefore, must be scrapped. As a result, despite the lower ratio of defective memory cells, greater integration density means reduced manufacturing yield.

In a metal-insulator-semiconductor (MIS) RAM, in order to overcome the problem of defective memory cells, use is made of redundancy memory cells. When a defective memory cell is detected, a redundancy memory cell row or column is selected instead of the memory cell row or column including the defective memory cell. In general, one or two redundancy memory cell rows or columns are usually provided.

In such a redundancy configuration, in order to store address information of such a defective row or column and to disable regular decoders for selecting normal memory cells so as to select the redundancy row or column in response to an address of the defective row or column, a defective address memory circuit is required.

In the prior art, however, since there has been no preferably defective address memory circuit for a bipolar-transistor type RAM, there has been no bipolar-transistor type RAM having a redundancy configuration.

EP-A-0087610 describes a random access memory having a word group redundancy scheme using redundant and non redundant memory portions each with word group decoders a compare circuit and addressing means.

It is an object of the invention to provide an information memory circuit suitable for a defective address memory circuit of the bipolar-transistor type RAM having a redundancy configuration.

According to the present invention there is provided a semiconductor memory device of a bipolar-transistor type comprising; a memory cell array; a redundancy memory cell array; means for receiving an address signal; means for selecting a normal memory cell from said memory cell array in accordance with said address signal from said address receiving means; and means for comparing the address of said address signal from said address receiving means with said defective address of a defective memory cell of said memory cell array so as to disable said normal memory cell selecting means and select said redundancy memory cell array when the address of said address signal is different from said defective address characterised by means for storing said defective address and comprising a plurality of 1-bit memory circuits of a diode type, each circuit corresponding to each bit of said defective address.

According to another aspect of the invention, there is provided an information memory circuit including at least three diode stages along a forward bias direction between a first power supply and a node; a diode stage linked along a backward bias direction between a write power supply and the first power supply; a shorted-junction type programmable read-only memory (PROM) cell linked between the write power supply and the node; and a switching element linked between the node and a second power supply for receiving a one bit address signal, thereby generating a high or low potential from the node in accordance with the short-circuited or non-short-circuited state of the PROM cell.

In the above-mentioned information memory circuit, two diode stages can be provided instead of the three or more diode stages, and in this case, the diode along the backward bias direction is changed by one resistor, or one diode stage along a forward bias direction is provided on the side of the first power supply.

According to a further aspect of the invention, there is provided an information memory circuit including at least three diode stages along a forward bias direction between a first power supply and a first node; a resistor linked between the first node and a second power supply; a diode stage linked between the first and second nodes and having the same conduction direction as the three or more diode stages; a resistor linked between the second node and the second power supply; a diode stage linked along a forward bias direction between the first power supply and a write power supply; a short-circuited-junction type PROM cell linked between the write power supply and the second node; and a switching element, linked between the second node and the second power supply for receiving a one bit address signal and an output circuit, connected to the first and second nodes, for detecting the difference in potential in accordance with the short-circuited or non-short-circuited state of the PROM cell.

In the above-mentioned information memory circuit, in order to separate the circuits for determining the potential at each of the first and second nodes, three diode stages are added to the second node. Also, the diode between the first power supply and the write power supply can be replaced by a resistor, and one stage of the three diode stages can be omitted. Also, the diode stage between the first power supply and the write power supply can be detected. However, instead of this, a diode stage is provided on the first power supply.

In the above-mentioned configuration, if the short-circuited junction type PROM cell is not destroyed, the potential at the first node is low. On the other hand, if the short-circuited junction type PROM cell is destroyed, the potential at the first node is high. The data of the PROM cell can be read out by detecting the potential at the first node. Note that the difference in potential at the first node between the non-destroyed state and the destroyed state of the PROM cell corresponds to the forward direction potential of one diode stage.

Embodiments of the invention will now be described, by way of example, with reference to the accompanying drawings, wherein:

Fig. 1 is a block diagram illustrating one example of a semiconductor device according to the invention;

Fig. 2 is a block diagram of an address memory circuit of the device of Figure 1;

Figs. 3 to 10 are circuit diagrams of alternative forms of the 1-bit memory circuit of Fig. 2;

Figs. 11A and 11B are circuit diagrams of a comparing circuit of Figure 2; and

Figs. 12A and 12B together form a block diagram illustrating another example of a semiconductor device according to the invention.

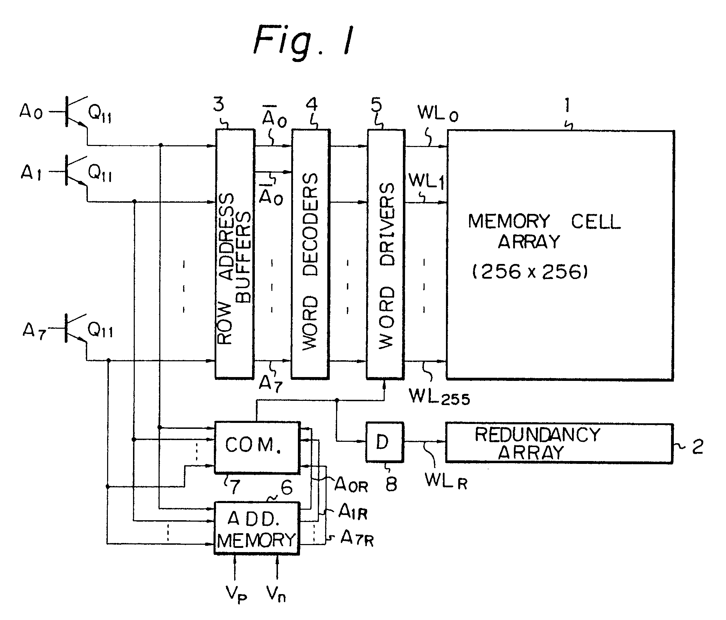

In Fig. 1, which illustrates an embodiment of the present invention, a memory device comprises a 64K-bit static memory cell array 1, and a redundancy array 2. Note that the redundancy array can comprise more than two rows or columns, but, in this case, a one-row array is described in order to simplify the explanation. One row of the memory cell array 1 is selected by row address buffers 3, word decoders 4, and word drivers 5. That is, external row address signals $A_0$, $A_1$ ..., $A_7$ are received by emitter-followers $Q_{11}$ and are converted by the row address buffers 3 into internal row address signals $A_0$, $A_1$, ..., and $A_7$, and their inverted signals $\overline{A_0}$ $\overline{A_1}$, ..., $\overline{A_7}$, which are received by the word decoders 4 which drive one of the 256 word drivers 5, i.e. one of the word lines $WL_0$, $WL_1$, ..., $WL_{255}$. Similarly, one column of the memory cell array 1 is selected by column selection means (not shown).

The device further comprises a defective address memory circuit 6, an address comparing circuit 7 for comparing an input address defined by the external address signals $A_0$, $A_1$, ..., and $A_7$ with the defective address defined by signals $A_{0R}$, $A_{1R}$, ..., and $A_{7R}$ stored in the defective address memory circuit 6, and a driver circuit 8 for driving the redundancy array 2.

If all of the memory cells are normal, no problem occurs and, accordingly, the circuit of Fig. 1 operates in the same way as the conventional devices. However, if a defective cell is detected in the memory cell array 1 of Fig. 1, the row address of a row including this defective cell (hereinafter referred to as a defective row address) is written into the defective address memory circuit 6. The row address signals $A_0$, $A_1$, ..., and $A_7$ are always compared with the defective address signals $A_{0R}$, $A_{1R}$, ..., and $A_{7R}$ written into the address memory circuit 6. As a result, when any of the address signals $A_0$, $A_1$, ..., and $A_7$ coincide with the defective row address signals $A_{0R}$, $A_{1R}$, ..., and $A_{7R}$, respectively, the address comparing circuit 7 operates the driver 8 to select the word line $WL_R$ and drive the redundancy array 2, and simultaneously to disable the word drivers 5, thereby causing non-selection of the memory cell array 1.

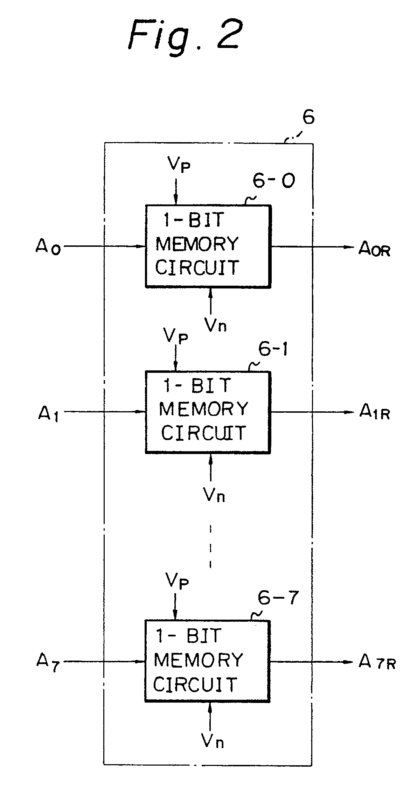

In Fig. 2, which is a detailed block circuit diagram of the defective address memory circuit 6 of Fig. 1, the circuit 6 comprises 1-bit memory circuits 6-0, 6-1, ..., and 6-7 corresponding to each of the row address signals $A_0$, $A_1$, ..., and $A_7$. That is, the row address signals $A_0$, $A_1$, ..., and $A_7$ are applied thereto, a high voltage such as +5 V is applied as a write voltage to the write terminal $V_P$, and a low voltage such as -5 V is applied to the other terminal $V_n$. Then, the row address signals $A_0$, $A_1$, ..., and $A_7$ are written into the 1-bit memory circuits 6-0, 6-1, ..., and 6-7, respectively. Thus, these signals can be read out as the defective address signals, ..., $A_{0R}$, $A_{1R}$, ..., and $A_{7R}$.

Hereinafter, the 1-bit memory circuits will be explained in more detail.

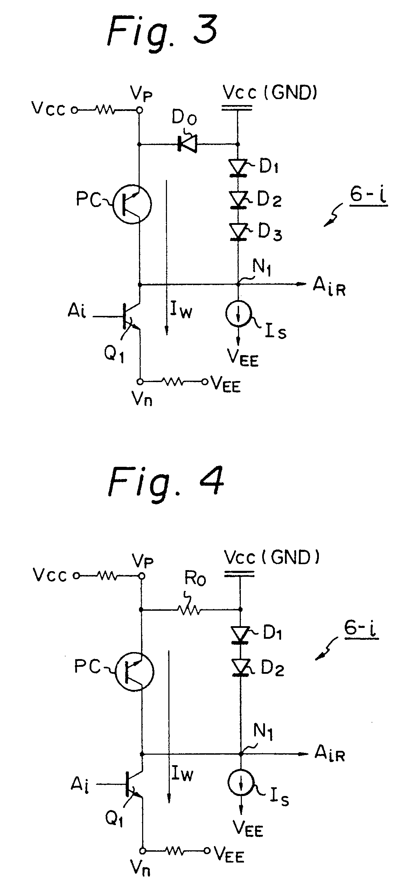

In Fig. 3, which illustrates a first example of the 1-bit memory circuit of Fig. 2, power supply $V_{CC}$ is, for example, the ground level GND, and power supply $V_{EE}$ is, for example, -5 V. If in a write mode for breaking down the PROM cell PC, the write power supply $V_P$ is +5 V, otherwise $V_P$ equals $V_{CC}$ (GND). Also, if in a write mode, the write power supply $V_n$ is lower than -5 V, otherwise $V_n$ equals $V_{EE}$ (-5 V). Further, PC designates a short-circuited junction type PROM cell which has diode characteristics after a write mode. That is, during a write mode, a larger voltage than the endurance voltage $C_E$ of the PROM cell, which is a kind of transistor, is applied to the emitter-collector thereof, thereby breaking it down.

Provided between the power supply $V_{CC}$ and node $N_1$ is a series of three diode stages $D_1$, $D_2$,

and $D_3$ , and a current source $I_S$ , thereby generating a voltage at node $N_1$ for a non-broken mode. In this case, the diode stages $D_1$ , $D_2$ , and $D_3$ are forwardly biased. That is, the potential at node $N_1$ is

$$-0.8 \times 3 = -2.4 \text{ V}$$

determined by the diode stages $D_1$ , $D_2$ , and $D_3$. Here, note that 0.8 V is the forward voltage of one diode stage. Also, in order to determine the potential at node $N_1$ after a writing mode for the PROM cell PC, diode stage $D_0$ is provided between the power supply $V_{CC}$ and the write power supply $V_P$. The diode stage $D_0$ is reversely biased during a write mode. After a write mode, since the PROM cell PC serves as a one diode stage, the potential at node $N_1$ is the voltage corresponding to two diode stages, i.e.,

$$-0.8 \times 2 = -1.6 \text{ V}.$$

Thus, in the circuit of Fig. 3, during a non-write (non broken-down) mode of the PROM cell PC, the potential at node $N_1$ is -2.4 V, and after a write mode, the potential at node $N_1$ is -1.6 V. Thus, the difference of 0.8 V in potential is generated at node $N_1$.

Note that a transistor $Q_1$ is used for a write operation of the PROM cell PC.

Next, the write operation of the circuit of Fig. 3 will be explained. In order to carry out a write operation, the write power supply $V_P$ is raised to +5 V from the exterior, while the write power supply $V_n$ is retained at -5 V. At this time, when the address signal $A_i$ is at a high level the write transistor $Q_1$ is turned ON. As a result, a voltage higher than the duration voltage $C_E$ such as 7 V (which voltage is, in this case, about 10 V) is applied to the PROM cell PC, and accordingly, a current $I_W$ flows through the emitter-collector of the PROM cell PC, thereby breaking down the emitter-base thereof.

In Fig. 4, which illustrates a second example of the 1-bit memory circuit of Fig. 2, the diode stages $D_0$ and $D_3$ of Fig. 3 are deleted, and a resistor $R_0$ is provided between the power supplies $V_{CC}$ and $V_P$. Note that the value of the resistor $R_0$ is relatively small. Therefore, the potential at node $N_1$ for a non-broken-mode is

$$-0.8 \times 2 = -1.6 \text{ V}$$

determined by the diodes $D_1$ and $D_2$ , and the potential at node $N_1$ after a write operation is -0.8 V. Thus, also in the circuit of Fig. 4, the difference 0.8 V in potential is generated at node $N_1$.

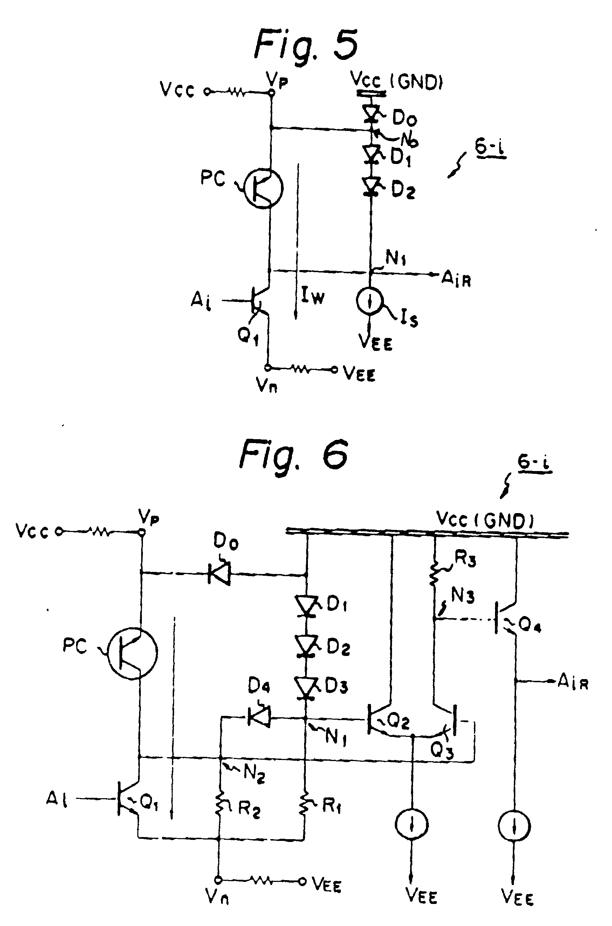

In Fig. 5, which illustrates a third example of the 1-bit memory circuit of Fig. 2, the resistor $R_0$ of Fig. 4 is deleted, and a diode $D_0$ is provided on the side of the power supply $V_{CC}$. However, the operation of the circuit of Fig. 5 is about the same as that of Fig. 4.

In Figs. 3, 4, and 5, a resistor can be provided instead of the current source $I_S$.

In Fig. 6, which ilustrates a fourth example of the 1-bit memory circuit of Fig. 2, provided between the power supplies $V_{CC}$ and $V_n$ is a series circuit formed by three diode stages $D_1$ , $D_2$ , and $D_3$ , and resistors $R_1$ and $R_2$ for generating a reference voltage. That is, the potential at node $N_1$ is the reference voltage which equals

$$-0.8 \times 3 = -2.4 \text{ V}$$

determined by the diode stages $D_1$ , $D_2$ , and $D_3$. Also, in order to determine the potential at node $N_2$ during a non-broken-mode of the PROM cell PC; a diode $D_4$ and a resistor $R_2$ are added to the diodes $D_1$ , $D_2$ , and $D_3$ between the power supplies $V_{CC}$ and $V_n$. That is, in this case, the potential at node $N_2$ is

$$-0.8 \times 4 = -3.2 \text{ V}$$

determined by the diodes $D_1$ , $D_2$ , $D_3$ , and $D_4$. Also, in this case, the potential at node $N_2$ after a write operation is

$$-0.8 \times 2 = -1.6 \text{ V}$$

determined by the diode stage $D_0$ and the PROM cell PC. Thus, in the circuit of Fig. 6, during a non-broken-mode of the PROM cell PC,

　　the potential at node $N_1$: -2.4 V,
and
　　the potential at node $N_2$: -3.2 V.
As a result, among transistors $Q_2$ and $Q_3$ forming a current switch, the transistor $Q_2$ is turned ON, while the transistor $Q_3$ is turned OFF, and therefore, the potential at node $N_3$ becomes at a high level ($V_{CC}$). Thus, as the base potential of an output transistor $Q_4$ increases, the potential of the defective address signal $A_{iR}$ becomes high. On the other hand, after a write mode of the PROM cell PC,

　　the potential at node $N_1$: -2.4 V,
and
　　the potential at node $N_2$: -1.6 V.
As a result, among the transistors $Q_2$ and $Q_3$ forming a current switch, the transistor $Q_2$ is turned OFF, while the transistor $Q_3$ is turned ON, and therefore, the potential at node $N_3$ becomes at a low level. Thus, as the base potential of the output transistor $Q_4$ decreases, the potential of the defective address signal $A_{iR}$ becomes low.

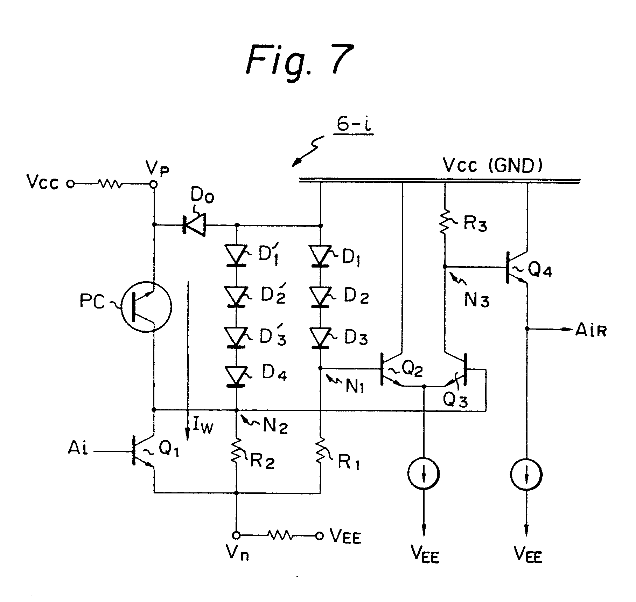

In Fig. 7, which illustrates a fifth example of the 1-bit memory circuit of Fig. 2, in order to separate the circuit for determining the potential at node $N_1$ from the circuit for determining the potential at node $N_2$ during a non-broken-mode, three diode stages $D_1'$, $D_2'$, and $D_3'$ are provided. However, the operation of the circuit of Fig. 7 is the same as that of Fig. 6.

Thus, in the circuits of Figs. 6 and 7, the potential at node $N_2$ is increased or decreased by the potential corresponding to one diode stage as compared with the reference voltage at node $N_1$, in accordance with the presence or absence of a write operation (breakdown) of the PROM cell PC. Also, the logic amplitude corresponding to one diode stage is read out by the following transistors $Q_2$, $Q_3$, and $Q_4$.

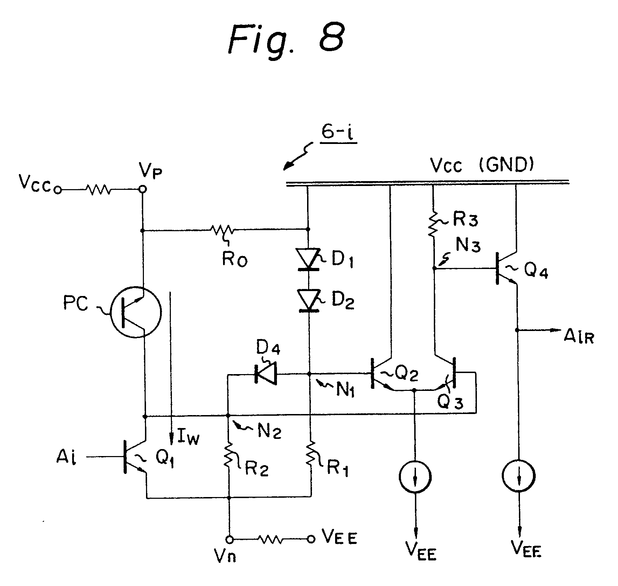

In Fig. 8, which illustrates a sixth example of the 1-bit memory circuit of Fig. 2, the diode $D_3$ of Fig. 6 is deleted, and a resistor $R_0$ is provided between the power supplies $V_{CC}$ and $V_P$. Note that the value of the resistor $R_0$ is relatively small. Therefore, the potential at node $N_1$ as the reference voltage is

-0.8 x 2 = -1.6 V

determined by the diodes $D_1$ and $D_2$. The potential at node $N_2$ during a non-broken-mode of the PROM cell PC is

-0.8 x 3 = -2.4 V

determined by the diodes $D_1$, $D_2$, and $D_4$. The potential at node $N_2$ after a write mode of the PROM cell PC is
-0.8 V
determined by the PROM cell PC corresponding to one diode stage. Thus, after a write mode of the PROM cell PC,
the potential at node $N_1$: -1.6 V;
and
the potential at node $N_2$: -2.4 V.
Thus, in the same way as in the circuit of Fig. 6, the potential of the defective address signal $A_{iR}$ is high. On the other hand, after a write mode of the PROM cell PC,
the potential at Node $N_1$: -1.6 V;
and
the potential at Node $N_2$: -0.8 V.
Thus, in the same way as in the circuit of Fig. 6, the potential of the defective address signal $A_{iR}$ is low.

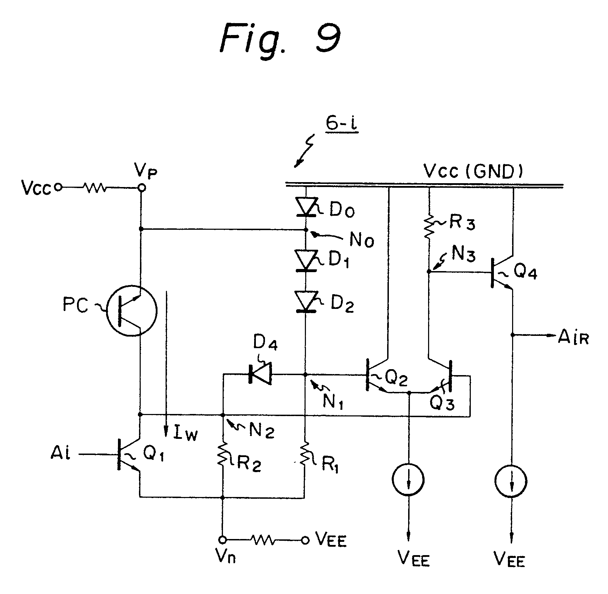

In Fig. 9, which illustrates a seventh example of the 1-bit memory circuit of Fig. 2, the resistor $R_0$ of Fig. 8 is deleted, and a diode $D_0$ is provided on the side of the power supply $V_{CC}$. However, the operation of the circuit of Fig. 9 is about the same as that of Fig. 8.

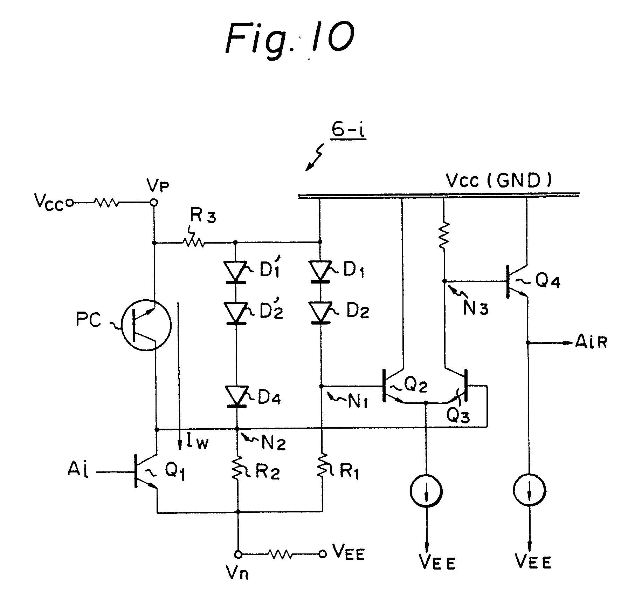

In Fig. 10, which illustrates an eighth example of the 1-bit memory circuit of Fig. 2, in order to separate the circuit for determining the potential at node $N_1$ from the circuit for determining the potential at node $N_2$, two diode stages $D_1'$ and $D_2'$ are added. However, the operation of circuit of Fig. 10 is the same as that of Fig. 8.

Thus, in the circuits of Figs. 8, 9, and 10, the potential at node $N_2$ is increased or decreased by the potential corresponding to one diode stage as compared with the reference voltage at node $N_1$, in accordance with the presence or absence of a write operation (breakdown) of the PROM cell PC. Also, the logic amplitude corresponding to one diode stage is read out by the following transistors $Q_2$, $Q_3$, and $Q_4$.

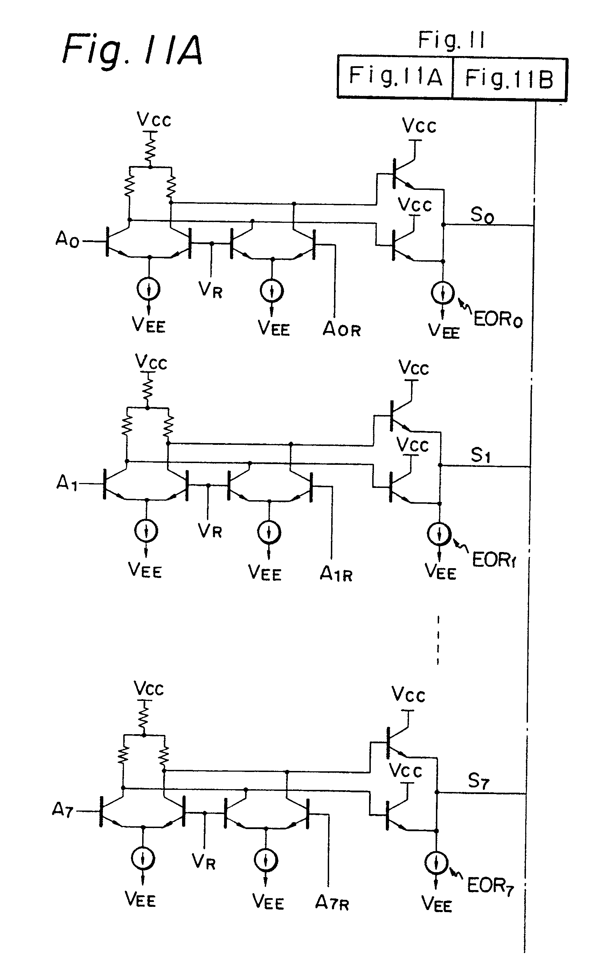

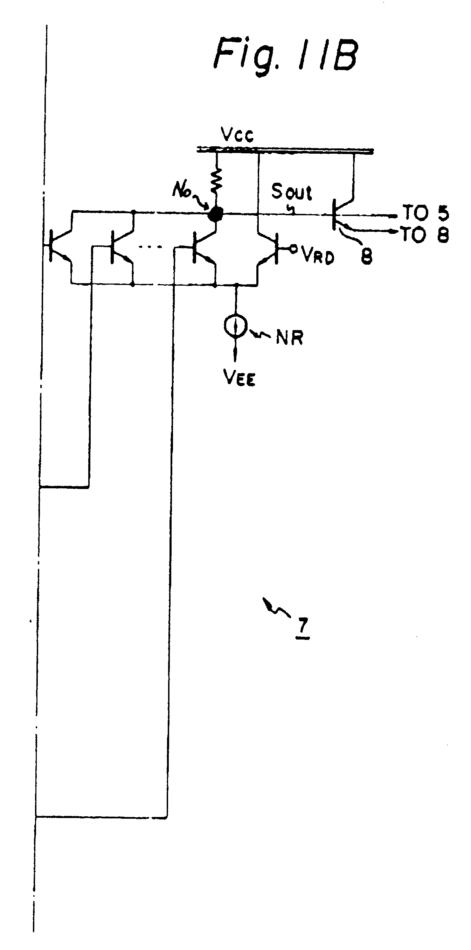

The output $A_{iR}$ of the circuit of Fig. 3, 4, 5, 6, 7, 8, 9, or 10 is supplied to the address comparing circuit 7 of Fig. 1. As illustrated in Figs. 11A and 11B, the address comparing circuit 7 comprises eight exclusive-OR circuits $EOR_0$, $EOR_1$, ..., $EOR_7$, and a NOR circuit NR. That is, when the address signals $A_0$, $A_1$, ..., and $A_7$ are completely coincided with the defective address signals $A_{0R}$, $A_{1R}$, ..., and $A_{7R}$, the outputs $S_0$, $S_1$, ..., and $S_7$ of the exclusive-OR circuits $ERO_0$, $EOR_1$, ..., and $EOR_7$ are all low, so that the output $S_{out}$ of the NOR circuit NR becomes high, thereby operating the driver 8 and, simultaneously, disabling the word drivers 5. On the other hand, when at least one bit of the address signals $A_0$, $A_1$, ..., and $A_7$ is not coincided with the corresponding one of the defective address signals $A_{0R}$, $A_{1R}$, ..., and $A_{7R}$, at least one of the outputs $S_0$, $S_1$, ..., and $S_7$ of the exclusive-OR circuits $EOR_0$, $EOR_1$, .., and $EOR_7$ is high, so that the output $S_{out}$ of the NOR circuit NR becomes low, thereby disabling the driver 8 and, simultaneously, enabling the word drivers 5.

In Fig. 11, note that $V_R$ is a reference voltage, which is predetermined as suitable for the logic amplitude of the defective address memory circuit 6-i. For example, in the case of the circuit as illustrated in Fig. 3 or 5, $V_R$ is about -2.0 V, while in the case of the circuit as illustrated in Fig. 4, $V_R$ is about -1.2 V. Also, $V_{RD}$ of Fig. 11 is a predetermined reference voltage.

Note that the number of diode stages ($D_1$, $D_2$, and $D_3$) of Figs. 3 through 10 can be increased. However, in Fig. 7 (or 10), when the number of diode stages $D_1$ to $D_3$ (or $D_1$ and $D_2$) is increased, the number of diode stages $D_1'$ to $D_3'$ (or $D_1'$ and $D_2'$) must be also increased.

In the 1-bit memory circuits as illustrated in Figs. 3 through 10, the logic amplitude is defined by the number of diode stages, and accordingly, such circuits are helpful in the configuration of the defective address memory circuit for storing a defective address in a bipolar-transistor type RAM having a redundancy configuration.

However, in the case of a write operation in the circuits of Figs. 3 through 10, a very large write current $I_W$ is necessary, and as a result, the write transistor $Q_1$ becomes large and also its load becomes large. Therefore, as illustrated in Fig. 1, when the address signals $A_0$ , $A_1$ , ..., and $A_7$ having a large logic amplitude are supplied directly to the row address buffers 3 and to the defective address memory circuit 6, the large load of the write transistor $Q_1$ is also applied to the address signals $A_0$ , $A_1$ , ..., and $A_7$ even during a non-write mode, thus causing a problem wherein an address access time is delayed during a normal state.

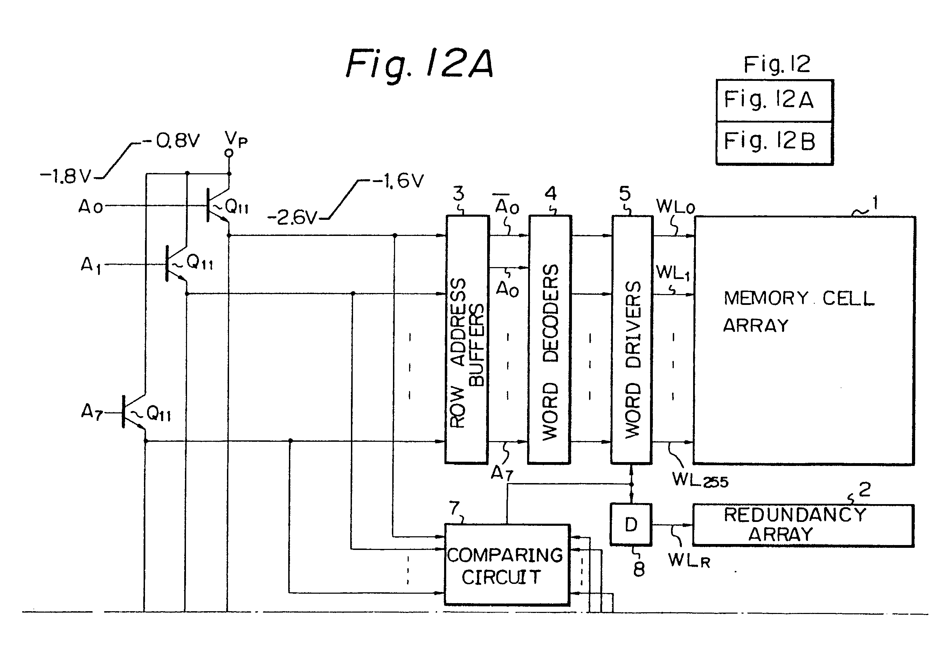

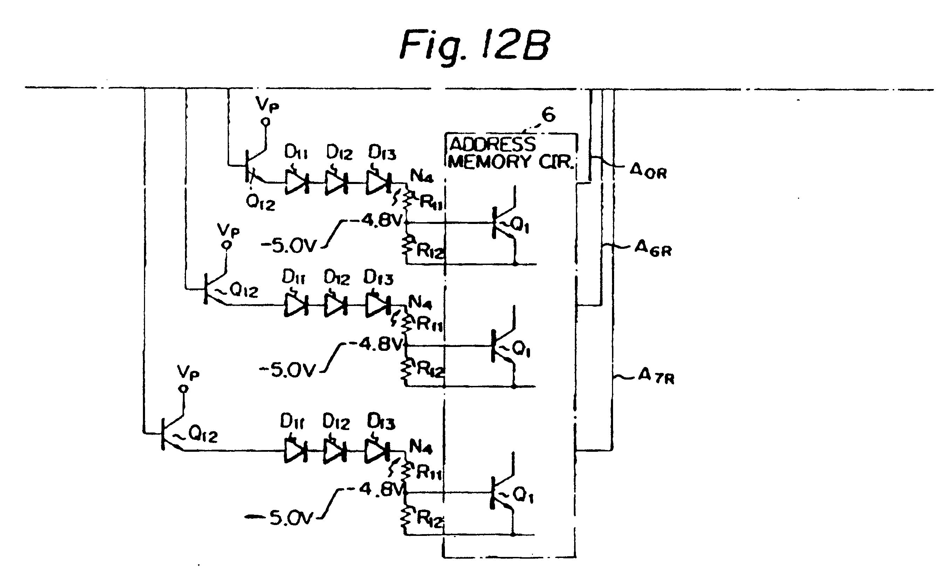

In Figs. 12A and 12B, which illustrates another embodiment of the present invention, each of the row address signals $A_0$ , $A_1$ , ..., and $A_7$ are supplied via emitter-followers $Q_{11}$ and $Q_{12}$ , diodes $D_{11}$ , $D_{12}$ , and $D_{13}$ , and resistors $R_{11}$ and $R_{12}$ to the defective address memory circuit 6. For example, if the high and low levels of an address signal are -0.8 V and -1.8 V, respectively, the address amplitude is 1.0 V (= 1.8 - 0.8), and therefore, the high and low levels at the inputs of the row address buffers 3 are -1.6 V (= -0.8 - 0.8) and -2.6 (= -1.8 - 0.8), respectively, and the address amplitude is also 1.0 V. On the other hand, at each node $N_4$ on the input side of the defective address memory circuit 6, the high level -0.8 V of the address signals $A_0$ , $A_1$ , ..., and $A_7$ becomes

-0.8 - 0.8 x 5 = -4.8 V

by two stages of the emitter-followers and three stages of the diodes $D_{11}$ , $D_{12}$ , and $D_{13}$ , and also the low level -1.8 V becomes

-1.8 - 0.85 x 5 = -5.8 V

by two stages of the emitter-followers $Q_{11}$ and $Q_{12}$ and three stages of the diodes. In this case, since the lowest power supply voltage is -5.0 V, the low level at each node $N_3$ is -5.0 V. Therefore, the address amplitude at each node $N_3$ is small and is 0.2 V (= 5.0 - 4.8). The address amplitude of the gates of the write transistors $Q_1$ is further decreased by resistors $R_{11}$ and $R_{12}$. For example, when the address amplitude is at the gates of the write transistors $Q_1$ , the address amplitude is reduced 0.1/1 = 1/10 by the two stages of the emitter followers, the three stages of the diodes, and the resistors.

Thus, during a non-write mode, since the address amplitude input to the defective address memory circuit 6 is reduced as compared with the address amplitude input to the row address buffers 3, application of a large load of the write transistors $Q_1$ can be substantially avoided to the address buffers 3. That is, even when the gate capacity $C_G$ of the transistor $Q_1$ is large, the fluctuation of charges $C_G \Delta V$ is reduced if the voltage amplitude $\Delta V$ is reduced. Thus, the load of the write transistors can be neglected.

During a write mode, since the voltage $V_P$ is increased from 0 V to 5 V, the address amplitude at the write transistors $Q_1$, becomes large, and in this case, the address amplitude at the address buffers 3 also increases, which, however, has no effect on the address buffers 3 during a write mode.

Note that, in Fig. 12, two stages of emitter-followers, three stages of diodes, and the like are used as the level shift down means. However, the number of such stages can be modified as occasion demands or in accordance with the power supply voltage. For example, all the five stages may consist of diodes. Also, if the write voltage is high, the number of such stages can be more than 6. Further, if the lowest power supply voltage is higher than -5 V, the number of such stages can be less than 4.

Thus, in Figs. 12A and 12B, during a no-write mode, since the address amplitude applied to the write transistors $Q_1$ can be reduced, the large load of these write transistors is not applied to the address signals, and as a result, the address access time can be reduced.

## Claims

1. A semiconductor memory device of a bipolar-transistor type comprising;

   a memory cell array (1);

   a redundancy memory cell array (2);

   means for receiving an address signal ($A_0$ ~ $A_7$);

   means (3, 4, 5) for selecting a normal memory cell from said memory cell array in accordance with said address signal ($A_0$ ~ $A_7$) from said address receiving means; and

   means (7) for comparing the address of said address signal ($A_0$ ~ $A_7$) from said address receiving means with said defective address ($A_{0R}$ ~ $A_{7R}$) of a defective memory cell of said memory cell array (1) so as to disable said normal memory cell selecting means (3, 4, 5) and select said redundancy memory cell array (2) when the address of said address signal ($A_0$ ~ $A_7$) is different from said defective address ($A_{0R}$ ~ $A_{7R}$);

   characterised by:

   means (6) for storing said defective address and comprising a plurality of 1-bit memory circuits (6-0, 6-1, ..., 6-7) of a diode type, each circuit corresponding to each bit of said defective address ($A_{0R}$ ~ $A_{7R}$).

2. A device as set forth in claim 1, wherein each of 1-bit memory circuits (6-0 ~ 6-7) comprises;

a first power supply means ($V_{CC}$);

a second power supply means ($V_{EE}$);

a write power supply means ($V_P$);

a node ($N_1$);

at least three diode stages ($D_1$ ~ $D_3$) linked along a forward bias direction between said first power supply means ($V_{CC}$) and said node ($N_1$);

a current source ($I_S$) or resistor linked between said node ($N_1$) and said second power supply means ($V_{EE}$);

a diode stage ($D_0$) linked along a backward bias direction between said write power supply means ($V_P$) and said first power supply means ($V_{CC}$);

a short-circuited junction type PROM cell (PC) linked between said write power supply means ($V_P$) and said node ($N_1$); and

a switching element ($Q_1$), linked between said node ($N_1$) and said second power supply means ($V_{EE}$), for receiving one bit of said address signal ($A_0$ ~ $A_7$),

whereby generating a high or low potential from said node ($N_1$) in accordance with the short-circuited or non-short-circuited state of said PROM cell (PC).

3. A device as set forth in claim 1, wherein each of 1-bit memory circuits (6-0 ~ 6-7) comprises;

a first power supply means ($V_{CC}$);

a second power supply means ($V_{EE}$);

a write power supply means ($V_P$);

a node ($N_1$);

at least two diode stage ($D_1$ , $D_2$) linked along a forward bias direction between said first power supply means ($V_{CC}$) and said node ($N_1$);

a current source ($I_S$) or resistor linked between said node ($N_1$) and said second power supply means ($V_{EE}$);

a resistor ($R_0$) linked between said write power supply means ($V_P$) and said first power supply means ($V_{CC}$);

a short-circuited junction type PROM cell (PC) linked between said write power supply means ($V_P$) and said node ($N_1$); and

a switching element ($Q_1$), linked between said node ($N_1$) and said second power supply means ($V_{EE}$), for receiving one bit of said address signal ($A_0$ ~ $A_7$),

whereby generating a high or low potential from said node ($N_1$) in accordance with the short-circuited or non-short-circuited state of said PROM cell (PC).

4. A device as set forth in claim 1, wherein each of 1-bit memory circuits (6-0 ~ 6-7) comprises;

a first power supply means ($V_{CC}$);

a second power supply means ($V_{EE}$);

a write power supply means ($V_P$);

first and second nodes ($N_0$ , $N_1$);

a diode stage ($D_0$) linked along a forward bias direction between said first power supply means ($V_{CC}$) and said first node ($N_0$);

at least two diode stages ($D_1$ , $D_2$) linked along a forward bias direction between said first node ($N_0$) and said second node ($N_1$);

a current source ($I_S$) or resistor linked between said second node ($N_1$) and said second power supply means ($V_{EE}$);

a direct link between said write power supply means ($V_P$) and said first node ($N_0$);

a short-circuited junction type PROM cell (PC) linked between said write power supply means ($V_P$) and said second node ($N_1$); and

a switching element ($Q_1$), linked between said second node ($N_1$) and said second power supply means ($V_{EE}$), for receiving one bit of said address signal ($A_0$ ~ $A_7$),

whereby generating a high or low potential from said node ($N_1$) in accordance with the short-circuited or non-short-circuited state of said PROM cell (PC).

5. A device as set forth in claim 1, wherein each of said 1-bit memory circuits (6-0 ~ 6-7) comprises;

a first power supply means ($V_{CC}$);

a second power supply means ($V_{EE}$);

a write power supply means ($V_P$);

first and second nodes ($N_1$ , $N_2$);

at least three diode stages ($D_1$ ~ $D_3$) along a forward bias direction between said first power supply means ($V_{CC}$) and said first node ($N_1$);

a first resistor ($R_1$) linked between said first node ($N_1$) and said second power supply means ($V_{EE}$);

a diode stage ($D_4$) linked between said first and second nodes ($N_1$ , $N_2$), and having the same conduction direction as said at least three diode stages ($D_1$ ~ $D_3$);

a second resistor ($R_2$) linked between said second node ($N_2$) and said second power supply means ($V_{EE}$);

a diode stage ($D_0$) linked along a forward bias direction linked between said first power supply means ($V_{CC}$) and said write power supply means ($V_P$);

a short-circuited junction type PROM cell (PC) linked between said write power supply means ($V_P$) and said second node ($N_2$);

a switching element ($Q_1$), linked between said second node ($N_2$) and said second power supply means ($V_{EE}$), for receiving one bit of

said address signal ($A_0 \sim A_7$); and

output means ($Q_2 \sim Q_4$, $R_3$), connected to said first and second nodes ($N_1$, $N_2$), for detecting the difference in potential in accordance with the short-circuited or non-short-circuited state of said PROM cell (PC).

6. A device as set forth in claim 1, wherein each of said 1-bit memory circuits (6-0 ~ 6-7) comprises;

a first power supply means ($V_{CC}$);

a second power supply means ($V_{EE}$);

a write power supply means ($V_P$);

first and second nodes ($N_1$, $N_2$);

at least three diode stages ($D_1 \sim D_3$) along a forward bias direction between said first power supply means ($V_{CC}$) and said first node ($N_1$);

a first resistor ($R_1$) linked between said first node ($N_1$) and said second power supply means ($V_{EE}$);

at least four diode stages ($D_1' \sim D_3'$, $D_4$) linked along a forward bias direction between said first power supply means ($V_{CC}$) and said second node ($N_2$);

a second resistor ($R_2$) linked between said second node ($N_2$) and said second power supply means ($V_{EE}$);

a diode stage ($D_0$) linked along a forward bias direction linked between said first power supply means ($V_{CC}$) and said write power supply means ($V_P$); and

a short-circuited-junction type PROM cell (PC) linked between said write power supply means ($V_P$) and said second node ($N_2$);

a switching element ($Q_1$), linked between said second node ($N_2$) and said second power supply means ($V_{EE}$), for receiving one bit of said address signal ($A_0 \sim A_7$); and

output means ($Q_2 \sim Q_4$, $R_3$), connected to said first and second nodes ($N_1$, $N_2$), for detecting the difference in potential in accordance with the short-circuited or non-short-circuited state of said PROM cell (PC).

7. A device as set forth in claim 1, wherein each of said 1-bit memory circuits (6-0 ~ 6-7) comprises;

a first power supply means ($V_{CC}$);

a second power supply means ($V_{EE}$);

a write power supply means ($V_P$);

first and second nodes ($N_1$, $N_2$);

at least two diode stages ($D_1$, $D_2$) along a forward bias direction between said first power supply means ($V_{CC}$) and said first node ($N_1$);

a first resistor ($R_1$) linked between said first node ($N_1$) and said second power supply means ($V_{EE}$);

a diode stage ($D_4$) linked between said first and second nodes ($N_1$, $N_2$), and having the same conduction direction as said at least two diode stages ($D_1$, $D_2$);

a second resistor ($R_2$) linked between said second node ($N_2$) and said second power supply means ($V_{EE}$);

a resistor ($R_0$) linked between said first power supply means ($V_{CC}$) and said write power supply means ($V_P$);

a short-circuited-junction type PROM cell (PC) linked between said write power supply means ($V_P$) and said second node ($N_2$);

a switching element ($Q_1$), linked between said second node ($N_2$) and said second power supply means ($V_{EE}$), for receiving one bit of said address signal ($A_0 \sim A_7$); and

output means ($Q_2 \sim Q_4$, $R_3$), connected to said first and second nodes ($N_1$, $N_2$), for detecting the difference in potential in accordance with the short-circuited or non-short-circuited state of said PROM cell (PC).

8. A device as set forth in claim 1, wherein each of said 1-bit memory circuits (6-0 ~ 6-7) comprises;

a first power supply means ($V_{CC}$);

a second power supply means ($V_{EE}$);

a write power supply means ($V_P$);

first, second, and third nodes ($N_0$, $N_1$, $N_2$);

a diode stage ($D_0$) linked along a forward bias direction between said first power supply means ($V_{CC}$) and said first node ($N_0$);

at least two diode stages ($D_1$, $D_2$) along a forward bias direction between said first and second nodes ($N_0$, $N_1$);

a first resistor ($R_1$) linked between said second node ($N_1$) and said second power supply means ($V_{EE}$);

a diode stage ($D_4$) linked between said first and second nodes ($N_1$, $N_2$), and having the same conduction direction as said at least two diode stages ($D_1$, $D_2$);

a direct link between said first node ($N_0$) and said write power supply means ($V_P$);

a second resistor ($R_2$) linked between said second node ($N_2$) and said second power supply means ($V_{EE}$);

a short-circuited junction type PROM cell (PC) linked between said write power supply means ($V_P$) and said third node ($N_2$);

a switching element ($Q_1$), linked between said third node ($N_2$) and said second power supply means ($V_{EE}$), for receiving one bit of said address signal ($A_0 \sim A_7$); and

output means ($Q_2 \sim Q_4$, $R_3$), connected to said second and third nodes ($N_1$, $N_2$), for detecting the difference in potential in accordance with the short-circuited or non-short-circuited state of said PROM cell (PC).

9. A device as set forth in claim 1, wherein each of said 1-bit memory circuits (6-0 ~ 6-7) comprises;

a first power supply means ($V_{CC}$);

a second power supply means ($V_{EE}$);

a write power supply means ($V_P$);

first and second nodes ($N_1$, $N_2$);

at least two diode stages ($D_1$, $D_2$) along a forward bias direction between said first power supply means ($V_{CC}$) and said first node ($N_1$);

a first resistor ($R_1$) linked between said first node ($N_1$) and said second power supply means ($V_{EE}$);

at least three diode stages ($D_1'$, $D_2'$, $D_4$) linked along a forward bias direction between said first power supply means ($V_{CC}$) and said second node ($N_2$);

a second resistor ($R_2$) linked between said second node ($N_2$) and said second power supply means ($V_{EE}$);

a resistor ($R_3$) linked between said first power supply means ($V_{CC}$) and said write power supply means ($V_P$);

a short-circuited junction type PROM cell (PC) linked between said write power supply means ($V_P$) and said second node ($N_2$);

a switching element ($Q_1$), linked between said second node ($N_2$) and said second power supply means ($V_{EE}$), for receiving one bit of said address signal ($A_0$ ~ $A_7$); and

output means ($Q_2$ ~ $Q_4$, $R_3$), connected to said first and second nodes ($N_1$, $N_2$), for detecting the difference in potential in accordance with the short-circuited or non-short-circuited state of said PROM cell (PC).

10. A device as set forth in claim 1, further comprising means,

linked between said address receiving means and said defective address storing means, for transmitting said address signal ($A_0$ ~ $A_7$) to said defective address storing means during a defective address writing mode and allowing no transmission of said address signal ($A_0$ ~ A7) to said defective address storing means.

11. A device as set forth in claim 10, wherein said switching means comprises level shift means for reducing the output amplitude of said address receiving means so that the input amplitude of said defective address storing means is smaller than the output amplitude of said defective address storing means.

12. A device as set forth in claim 11, wherein said level shift means comprises one or more stages of emitter followers, diodes, or resistors.

13. An information memory device comprising:

a first power supply means ($V_{CC}$);

a second power supply means ($V_{EE}$);

a write power supply means ($V_P$);

a node ($N_1$);

at least three diode stages ($D_1$ ~ $D_3$) linked along a forward bias direction between said first power supply means ($V_{CC}$) and said node ($N_1$);

a current source ($I_S$) or resistor linked between said node ($N_1$) and said second power supply means ($V_{EE}$);

a diode stage ($D_0$) linked along a backward bias direction between said write power supply means ($V_P$) and said first power supply means ($V_{CC}$);

a short-circuited-junction type PROM cell (PC) linked between said write power supply means ($V_P$) and said node ($N_1$); and

a switching element ($Q_1$), linked between said node ($N_1$) and said second power supply means ($V_{EE}$), for receiving a one bit address signal,

whereby generating a high or low potential from said node ($N_1$) in accordance with the short-circuited or non-short-circuited state of said PROM cell (PC).

14. An information memory device comprising:

a first power supply means ($V_{CC}$);

a second power supply means ($V_{EE}$);

a write power supply means ($V_P$);

a node ($N_1$);

at least two diode stages ($D_1$, $D_2$) linked along a forward bias direction between said first power supply means ($V_{CC}$) and said node ($N_1$);

a current source ($I_S$) or resistor linked between said node ($N_1$) and said second power supply means ($V_{EE}$);

a resistor ($R_0$) linked between said write power supply means ($V_P$) and said first power supply means ($V_{CC}$);

a short-circuited-junction type PROM cell (PC) linked between said write power supply means ($V_P$) and said node ($N_1$); and

a switching element ($Q_1$), linked between said node ($N_1$) and said second power supply means ($V_{EE}$), for receiving a one bit address signal,

whereby generating a high or low potential from said node ($N_1$) in accordance with the short-circuited or non-short-circuited state of said PROM cell (PC).

**15.** An information memory device comprising:

a first power supply means ($V_{CC}$);

a second power supply means ($V_{EE}$);

a write power supply means ($V_P$);

first and second nodes ($N_0$, $N_1$);

a diode stage ($D_0$) linked along a forward bias direction between said first power supply means ($V_{CC}$) and said first node ($N_0$);

at least two diode stages ($D_1$, $D_2$) linked along a forward bias direction between said first node ($N_0$) and said second node ($N_1$);

a current source ($I_S$) or resistor linked between said second node ($N_1$) and said second power supply means ($V_{EE}$);

a direct link between said write power supply means ($V_P$) and said first node ($N_0$);

a short-circuited junction type PROM cell (PC) linked between said write power supply means ($V_P$) and said second node ($N_1$); and

a switching element ($Q_1$), linked between said second node ($N_1$) and said second power supply means ($V_{EE}$), for receiving a one bit address signal,

whereby generating a high or low potential from said node ($N_1$) in accordance with the short-circuited or non-short-circuited state of said PROM cell (PC).

**16.** An information memory device comprising:

a first power supply means ($V_{CC}$);

a second power supply means ($V_{EE}$);

a write power supply means ($V_P$);

first and second nodes ($N_1$, $N_2$);

at least three diode stages ($D_1 \sim D_3$) along a forward bias direction between said first power supply means ($V_{CC}$) and said first node ($N_1$);

a first resistor ($R_1$) linked between said first node ($N_1$) and said second power supply means ($V_{EE}$);

a diode stage ($D_4$) linked between said first and second nodes ($N_1$, $N_2$), and having the same conduction direction as said at least three diode stages ($D_1 \sim D_3$);

a second resistor ($R_2$) linked between said second node ($N_2$) and said second power supply means ($V_{EE}$);

a diode stage ($D_0$) linked along a forward bias direction linked between said first power supply means ($V_{CC}$) and said write power supply means ($V_P$);

a short-circuited junction type PROM cell (PC) linked between said write power supply means ($V_P$) and said second node ($N_2$);

a switching element ($Q_1$), linked between said second node ($N_2$) and said second power supply means ($V_{EE}$), for receiving a one bit address signal; and

output means ($Q_2 \sim Q_4$, $R_3$), connected to said first and second nodes ($N_1$, $N_2$), for detecting the difference in potential in accordance with the short-circuited or non-short-circuited state of said PROM cell (PC).

**17.** An information memory device comprising:

a first power supply means ($V_{CC}$);

a second power supply means ($V_{EE}$);

a write power supply means ($V_P$);

first and second nodes ($N_1$, $N_2$);

at least three diode stages ($D_1 \sim D_3$) along a forward bias direction between said first power supply means ($V_{CC}$) and said first node ($N_1$);

a first resistor ($R_1$) linked between said first node ($N_1$) and said second power supply means ($V_{EE}$);

at least four diode stages ($D_1' \sim D_3'$, $D_4$) linked along a forward bias direction between said first power supply means ($V_{CC}$) and said second node ($N_2$);

a second resistor ($R_2$) linked between said second node ($N_2$) and said second power supply means ($V_{EE}$);

a diode stage ($D_0$) linked along a forward bias direction linked between said first power supply means ($V_{CC}$) and said write power supply means ($V_P$);

a short-circuited junction type PROM cell (PC) linked between said write power supply means ($V_P$) and said second node ($N_2$);

a switching element ($Q_1$), linked between said second node ($N_2$) and said second power supply means ($V_{EE}$), for receiving a one bit address signal; and

output means ($Q_2 \sim Q_4$, $R_3$), connected to said first and second nodes ($N_1$, $N_2$), for detecting the difference in potential in accordance with the short-circuited or non-short-circuited state of said PROM cell (PC).

**18.** An information memory device comprising:

a first power supply means ($V_{CC}$);

a second power supply means ($V_{EE}$);

a write power supply means ($V_P$);

first and second nodes ($N_1$, $N_2$);

at least two diode stages ($D_1$, $D_2$) along a forward bias direction between said first power supply means ($V_{CC}$) and said first node ($N_1$);

a first resistor ($R_1$) linked between said first node ($N_1$) and said second power supply means ($V_{EE}$);

a diode stage ($D_4$) linked between said first and second nodes ($N_1$, $N_2$), and having the same conduction direction as said at least two diode stages ($D_1$, $D_2$);

a second resistor ($R_2$) linked between said second node ($N_2$) and said second power supply means ($V_{EE}$);

a resistor (R$_0$) linked between said first power supply means (V$_{CC}$) and said write power supply means (V$_P$);

a short-circuited junction type PROM cell (PC) linked between said write power supply means (V$_P$) and said second node (N$_2$);

a switching element (Q$_1$), linked between said second node (N$_2$) and said second power supply means (V$_{EE}$), for receiving a one bit address signal; and

output means (Q$_2$ ~ Q$_4$ , R$_3$), connected to said first and second nodes (N$_1$ , N$_2$), for detecting the difference in potential in accordance with the short-circuited or non-short-circuited state of said PROM cell (PC).

19. An information memory device comprising:

a first power supply means (V$_{CC}$);

a second power supply means (V$_{EE}$);

a write power supply means (V$_P$);

first, second, and third nodes (N$_0$ , N$_1$ , N$_2$);

a diode stage (D$_0$) linked along a forward bias direction between said first power supply means (V$_{CC}$) and said first node (N$_0$);

at least two diode stages (D$_1$ , D$_2$) along a forward bias direction between said first and second nodes (N$_0$ , N$_1$);

a first resistor (R$_1$) linked between said second node (N$_1$) and said second power supply means (V$_{EE}$);

a diode stage (D$_4$) linked between said first and second nodes (N$_1$ , N$_2$), and having the same conduction direction as said at least two diode stages (D$_1$ , D$_2$);

a second resistor (R$_2$) linked between said second node (N$_2$) and said second power supply means (V$_{EE}$);

a direct link between said first node (N$_0$) and said write power supply means (V$_P$);

a short-circuited junction type PROM cell (PC) linked between said write power supply means (V$_P$) and said third node (N$_2$);

a switching element (Q$_1$), linked between said third node (N$_2$) and said second power supply means (V$_{EE}$), for receiving a one bit address signal; and

output means (Q$_2$ ~ Q$_4$ , R$_3$), connected to said second and third nodes (N$_1$ , N$_2$), for detecting the difference in potential in accordance with the short-circuited or non-short-circuited state of said PROM cell (PC).

20. An information memory device comprising:

a first power supply means (V$_{CC}$);

a second power supply means (V$_{EE}$);

a write power supply means (V$_P$);

first and second nodes (N$_1$ , N$_2$);

at least two diode stages (D$_1$ , D$_2$) along a forward bias direction between said first power supply means (V$_{CC}$) and said first node (N$_1$);

a first resistor (R$_1$) linked between said first node (N$_1$) and said second power supply means (V$_{EE}$);

at least three diode stages (D$_1$', D$_2$', D$_4$) linked along a forward bias direction between said first power supply means (V$_{CC}$) and said second node (N$_2$);

a second resistor (R$_2$) linked between said second node (N$_2$) and said second power supply means (V$_{EE}$);

a resistor (R$_3$) linked between said first power supply means (V$_{CC}$) and said write power supply means (V$_P$); and

a short-circuited junction type PROM cell (PC) linked between said write power supply means (V$_P$) and said second node (N$_2$);

a switching element (Q$_1$), linked between said second node (N$_2$) and said second power supply means (V$_{EE}$), for receiving a one bit address signal; and

output means (Q$_2$ ~ Q$_4$ , R$_3$), connected to said first and second nodes (N$_1$ , N$_2$), for detecting the difference in potential in accordance with the short-circuited or non-short-circuited state of said PROM cell (PC).

**Revendications**

1. Un dispositif de mémoire à semiconducteurs d'un type à transistors bipolaires, comprenant :

un réseau de cellules de mémoire (1);

un réseau de cellules de mémoire redondantes (2);

des moyens destinés à recevoir un signal d'adresse (A$_0$ à A$_7$);

des moyens (3, 4, 5) destinés à sélectionner une cellule de mémoire normale dans le réseau de cellules de mémoire conformément au signal d'adresse (A$_0$ à A$_7$) provenant des moyens de réception d'adresse; et

des moyens (7) destinés à comparer l'adresse du signal d'adresse (A$_0$ à A$_7$) provenant des moyens de réception d'adresse, avec l'adresse défectueuse (A$_{0R}$-A$_{7R}$)

d'une cellule de mémoire défectueuse du réseau de cellules de mémoire (1), de façon à invalider les moyens de sélection de cellule de mémoire normale (3, 4, 5) et à sélectionner le réseau de cellules de mémoire redondantes (2), lorsque l'adresse du signal d'adresse (A$_0$ à A$_7$) est différente de l'adresse défectueuse (A$_{0R}$ à A$_{7R}$);

caractérisé par :

des moyens (6) destinés à enregistrer l'adresse défectueuse, et comprenant un ensemble de circuits de mémoire à 1 bit (6-0, 6-1, ..., 6-7), d'un type à diodes, chaque circuit correspondant à chaque bit de l'adresse défectueuse ($A_{0R}$ à $A_{7R}$).

2. Un dispositif selon la revendication 1, dans lequel chacun des circuits de mémoire à 1 bit (6-0 à 6-7) comprend :
    des premiers moyens d'alimentation ($V_{CC}$);
    des seconds moyens d'alimentation ($V_{EE}$);
    des moyens d'alimentation d'écriture ($V_p$);
    un noeud ($N_1$);
    au moins trois étages de diode ($D_1$ à $D_3$) connectés avec une orientation correspondant à une polarisation en direct entre les premiers moyens d'alimentation ($V_{CC}$) et le noeud ($N_1$);
    une source de courant ($I_S$) ou une résistance connectée entre le noeud ($N_1$) et les seconds moyens d'alimentation ($V_{EE}$);
    un étage de diode ($D_0$) connecté avec une orientation correspondant à une polarisation en inverse entre les moyens d'alimentation d'écriture ($V_p$) et les premiers moyens d'alimentation ($V_{CC}$);
    une cellule de mémoire PROM du type à jonction court-circuitée (PC), connectée entre les moyens d'alimentation d'écriture ($V_p$) et le noeud ($N_1$); et
    un élément de commutation ($Q_1$), connecté entre le noeud ($N_1$) et les seconds moyens d'alimentation ($V_{EE}$), pour recevoir un bit du signal d'adresse ($A_0$ à $A_7$),
    pour générer ainsi un potentiel haut ou bas sur le noeud ($N_1$) conformément à l'état court-circuité ou non court-circuité de la cellule de mémoire PROM (PC).

3. Un dispositif selon la revendication 1, dans lequel chacun des circuits de mémoire à 1 bit comprend :
    des premiers moyens d'alimentation ($V_{CC}$);
    des seconds moyens d'alimentation ($V_{EE}$);
    des moyens d'alimentation d'écriture ($V_p$);
    un noeud ($N_1$);
    au moins deux étages de diode ($D_1$, $D_2$), connectés avec une orientation correspondant à une polarisation en direct entre les premiers moyens d'alimentation ($V_{CC}$) et le noeud ($N_1$);
    une source de courant ($I_S$) ou une résistance connectée entre le noeud ($N_1$) et les seconds moyens d'alimentation ($V_{EE}$);
    une résistance ($R_0$) connectée entre les moyens d'alimentation d'écriture ($V_p$) et les premiers moyens d'alimentation ($V_{CC}$);
    une cellule de mémoire PROM du type à jonction court-circuitée (PC), connectée entre les moyens d'alimentation d'écriture ($V_p$) et le noeud ($N_1$); et

un élément de commutation ($Q_1$), connecté entre le noeud ($N_1$) et les seconds moyens d'alimentation ($V_{EE}$), pour recevoir un bit du signal d'adresse ($A_0$ à $A_7$),
    pour générer ainsi un potentiel haut ou bas sur le noeud ($N_1$), conformément à l'état court-circuité ou non court-circuité de la cellule de mémoire PROM (PC).

4. Un dispositif selon la revendication 1, dans lequel chacun des circuits de mémoire à 1 bit (6-0 à 6-7) comprend :
    des premiers moyens d'alimentation ($V_{CC}$);
    des seconds moyens d'alimentation ($V_{EE}$);
    des moyens d'alimentation d'écriture ($V_p$);
    des premier et second noeuds ($N_0$, $N_1$);
    un étage de diode ($D_0$) connecté avec une orientation correspondant à une polarisation en direct entre les premiers moyens d'alimentation ($V_{CC}$) et le premier noeud ($N_0$);
    au moins deux étages de diode ($D_1$, $D_2$), connectés avec une orientation correspondant à une polarisation en direct entre le premier noeud ($N_0$) et le second noeud ($N_1$);
    une source de courant ($I_S$) ou une résistance connectée entre le second noeud ($N_1$) et les seconds moyens d'alimentation ($V_{EE}$);
    une liaison directe entre les moyens d'alimentation d'écriture ($V_p$) et le premier noeud ($N_0$);
    une cellule de mémoire PROM du type à jonction court-circuitée (PC), connectée entre les moyens d'alimentation d'écriture ($V_p$) et le second noeud ($N_1$); et
    un élément de commutation ($Q_1$), connecté entre le second noeud ($N_1$) et les seconds moyens d'alimentation ($V_{EE}$), pour recevoir un bit du signal d'adresse ($A_0$ à $A_7$),
    pour générer ainsi un potentiel haut ou bas sur le noeud ($N_1$), conformément à l'état court-circuité ou non court-circuité de la cellule de mémoire PROM (PC).

5. Un dispositif selon la revendication 1, dans lequel chacun des circuits de mémoire à 1 bit (6-0 à 6-7) comprend :
    des premiers moyens d'alimentation ($V_{CC}$);
    des seconds moyens d'alimentation ($V_{EE}$);
    des moyens d'alimentation d'écriture ($V_p$);
    des premier et second noeuds ($N_1$, $N_2$);
    au moins trois étages de diode ($D_1$ à $D_3$) connectés avec une orientation correspondant à une polarisation en direct, entre les premiers moyens d'alimentation ($V_{CC}$) et le premier noeud ($N_1$);
    une première résistance ($R_1$) connectée entre le premier noeud ($N_1$) et les seconds moyens d'alimentation ($V_{EE}$);

un étage de diode ($D_4$) connecté entre les premier et second noeuds ($N_1$, $N_2$), et ayant la même direction de conduction que les trois étages, ou plus, de diode ($D_1$ à $D_3$);

une seconde résistance ($R_2$) connectée entre le second noeud ($N_2$) et les seconds moyens d'alimentation ($V_{EE}$);

un étage de diode ($D_0$) connecté avec une orientation correspondant à une polarisation en direct, entre les premiers moyens d'alimentation ($V_{CC}$) et les moyens d'alimentation d'écriture ($V_p$);

une cellule de mémoire PROM du type à jonction court-circuitée (PC), connectée entre les moyens d'alimentation d'écriture ($V_p$) et le second noeud ($N_2$);

un élément de commutation ($Q_1$), connecté entre le second noeud ($N_2$) et les seconds moyens d'alimentation ($V_{EE}$), pour recevoir un bit du signal d'adresse ($A_0$ à $A_7$); et

des moyens de sortie [$Q_2$ à $Q_4$, $R_3$), connectés entre les premier et second noeuds ($N_1$, $N_2$), pour détecter la différence de potentiel qui correspond à l'état court-circuité ou non court-circuité de la cellule de mémoire PROM (PC).

6. Un dispositif selon la revendication 1, dans lequel chacun des circuits de mémoire à 1 bit (6-0 à 6-7) comprend :

des premiers moyens d'alimentation ($V_{CC}$);
des seconds moyens d'alimentation ($V_{EE}$);
des moyens d'alimentation d'écriture ($V_p$);
des premier et second noeuds ($N_1$, $N_2$);

au moins trois étages de diode ($D_1$ à $D_3$) connectés avec une orientation correspondant à une polarisation en direct, entre les premiers moyens d'alimentation ($V_{CC}$) et le premier noeud ($N_1$);

une première résistance ($R_1$) connectée entre le premier noeud ($N_1$) et les seconds moyens d'alimentation ($V_{EE}$);

au moins quatre étages de diode ($D'_1$ à $D'_3$, $D_4$), connectés avec une orientation correspondant à une polarisation en direct entre les premiers moyens d'alimentation ($V_{CC}$) et le second noeud ($N_2$);

une seconde résistance ($R_2$) connectée entre le second noeud ($N_2$) et les seconds moyens d'alimentation ($V_{EE}$);

un étage de diode ($D_0$) connecté avec une orientation correspondant à une polarisation en direct, entre les premiers moyens a'alimentation ($V_{CC}$) et les moyens d'alimentation d'écriture ($V_p$); et

une cellule de mémoire PROM du type à jonction court-circuitée (PC) connectée entre les moyens d'alimentation d'écriture ($V_p$) et le

second noeud ($N_2$);

un élément de commutation ($Q_1$), connecté entre le second noeud ($N_2$) et les seconds moyens d'alimentation ($V_{EE}$), pour recevoir un bit du signal d'adresse ($A_0$ à $A_7$); et

des moyens de sortie ($Q_2$ à $Q_4$, $R_3$), connectés entre les premier et second noeuds ($N_1$, $N_2$), pour détecter la différence de potentiel qui correspond à l'état court-circuité ou non court-circuité de la cellule de mémoire PROM (PC).

7. Un dispositif selon la revendication 1, dans lequel chacun des circuits de mémoire à 1 bit (6-0 à 6-7) comprend :

des premiers moyens d'alimentation ($V_{CC}$);
des seconds moyens d'alimentation ($V_{EE}$);
des moyens d'alimentation d'écriture ($V_p$);
des premier et second noeuds ($N_1$, $N_2$);

au moins deux étages de diode ($D_1$, $D_2$), connectés avec une orientation correspondant à une popolarisation en direct, entre les premiers moyens d'alimentation ($V_{CC}$) et le premier noeud ($N_1$);

une première résistance ($R_1$), connectée entre le premier noeud ($N_1$) et les seconds moyens d'alimentation ($V_{EE}$);

un étage de diode ($D_4$), connecté entre les premier et second noeuds ($N_1$, $N_2$), et ayant le même sens de conduction que les deux étages, ou plus, de diode ($D_1$, $D_2$);

une seconde résistance ($R_2$) connectée entre le second noeud ($N_2$) et les seconds moyens d'alimentation ($V_{EE}$);

une résistance ($R_0$) connectée entre les premiers moyens d'alimentation ($V_{CC}$) et les moyens d'alimentation d'écriture ($V_p$);

une cellule de mémoire PROM du type à jonction court-circuitée (PC), connectée entre les moyens d'alimentation d'écriture ($V_p$) et le second noeud ($N_2$);

un élément de commutation ($Q_1$), connecté entre le second noeud ($N_2$) et les seconds moyens d'alimentation ($V_{EE}$), pour recevoir un bit du signal d'adresse ($A_0$ à $A_7$); et

des moyens de sortie ($Q_2$ à $Q_4$, $R_3$), connectés aux premier et second noeuds ($N_1$, $N_2$), pour détecter la différence de potentiel qui correspond à l'état court-circuité ou non court-circuité de la cellule de mémoire PROM (PC).

8. Un dispositif selon la revendication 1, dans lequel chacun des circuits de mémoire à 1 bit (6-0 à 6-7) comprend :

des premiers moyens d'alimentation ($V_{CC}$);
des seconds moyens d'alimentation ($V_{EE}$);
des moyens d'alimentation d'écriture ($V_p$);
des premier, second et troisième noeuds

$(N_0, N_1, N_2)$;

un étage de diode $(D_0)$ connecté avec une orientation correspondant à une polarisation en direct entre les premiers moyens d'alimentation $(V_{CC})$ et le premier noeud $(N_0)$;

au moins deux étages de diode $(D_1, D_2)$ connectés avec une orientation correspondant à une polarisation en direct entre les premier et second noeuds $(N_0, N_1)$;

une première résistance $(R_1)$ connectée entre le second noeud $(N_1)$ et les seconds moyens d'alimentation $(V_{EE})$;

un étage de diode $(D_4)$ connecté entre les premier et second noeuds $(N_1, N_2)$, et ayant le même sens de conduction que les deux étages, ou plus, de diode $(D_1, D_2)$;

une première liaison directe entre le premier noeud $(N_0)$ et les moyens d'alimentation d'écriture $(V_p)$;

une seconde résistance $(R_2)$ connectée entre le second noeud $(N_2)$ et les seconds moyens d'alimentation $(V_{EE})$;

une cellule de mémoire PROM du type à jonction court-circuitée $(PC)$, connectée entre les moyens d'alimentation d'écriture $(V_p)$ et le troisième noeud $(N_2)$;

un élément de commutation $(Q_1)$, connecté entre le troisième noeud $(N_2)$ et les seconds moyens d'alimentation $(V_{EE})$, pour recevoir un bit du signal d'adresse $(A_0$ à $A_7)$; et

des moyens de sortie $(Q_2$ à $Q_4, R_3)$, connectés aux second et troisième noeuds $(N_1, N_2)$, pour détecter la différence de potentiel qui correspond à l'état court-circuité ou non court-circuité de la cellule de mémoire PROM $(PC)$.

9. Un dispositif selon la revendication 1, dans lequel chacun des circuits de mémoire à 1 bit (6-0 à 6-7) comprend :

des premiers moyens d'alimentation $(V_{CC})$;
des seconds moyens d'alimentation $(V_{EE})$;
des moyens d'alimentation d'écriture $(V_p)$;
de premier et second noeuds $(N_1, N_2)$;
au moins deux étages de diode $(D_1, D_2)$, connectés avec une orientation correspondant à une polarisation en direct, entre les premiers moyens d'alimentation $(V_{CC})$ et le premier noeud $(N_1)$;

une première résistance $(R_1)$ connectée entre la premier noeud $(N_1)$ et les seconds moyens d'alimentation $(V_{EE})$;

au moins trois étages de diode $(D'_1, D'_2, D_4)$ connectés avec une orientation correspondant à une polarisation en direct entre les premiers moyens d'alimentation $(V_{CC})$ et le second noeud $(N_2)$;

une seconde résistance $(R_2)$ connectée

entre le second noeud $(N_2)$ et les seconds moyens d'alimentation $(V_{EE})$;

une résistance $(R_3)$ connectée entre les premiers moyens d'alimentation $(V_{CC})$ et les moyens d'alimentation d'écriture $(V_p)$;

une cellule de mémoire PROM du type à jonction court-circuitée $(PC)$ connectée entre les moyens d'alimentation d'écriture $(V_p)$ et le second noeud $(N_2)$;

un élément de commutation $(Q_1)$, connecté entre le second noeud $(N_2)$ et les seconds moyens d'alimentation $(V_{EE})$, pour recevoir un bit du signal d'adresse $(A_0$ à $A_7)$; et

des moyens de sortie $(Q_2$ à $Q_4, R_3)$, connectés aux premier et second noeuds $(N_1, N_2)$, pour détecter la différence de potentiel qui correspond à l'état court-circuité ou non court-circuité de la cellule de mémoire PROM $(PC)$.

10. Un dispositif selon la revendication 1, comprenant en outre des moyens connectés entre les moyens de réception d'adresse et les moyens d'enregistrement d'adresses défectueuses, pour transmettre le signal d'adresse $(A_0$ à $A_7)$ aux moyens d'enregistrement d'adresses défectueuses pendant un mode d'écriture d'adresse défectueuse, et pour empêcher la transmission du signal d'adresse $(A_0$ à $A_7)$ aux moyens d'enregistrement d'adresses défectueuses.

11. Un dispositif selon la revendication 10, dans lequel les moyens de commutation comprennent des moyens de décalage de niveau qui sont destinés à réduire l'amplitude de sortie des moyens de réception d'adresse, de façon que l'amplitude d'entrée des moyens d'enregistrement d'adresses défectueuses soit inférieure à l'amplitude de sortie des moyens d'enregistrement d'adresses défectueuses.

12. Un dispositif selon la revendication 11, dans lequel les moyens de décalage de niveau comprennent un ou plusieurs étages de transistors à charge d'émetteur, de diodes ou de résistances.

13. Un dispositif de mémoire d'information comprenant :

des premiers moyens d'alimentation $(V_{CC})$;
des seconds moyens d'alimentation $(V_{EE})$;
des moyens d'alimentation d'écriture $(V_p)$;
un noeud $(N_1)$;
au moins trois étages de diode $(D_1$ à $D_3)$ connectés avec une orientation correspondant à une polarisation en direct entre les premiers moyens d'alimentation $(V_{CC})$ et le noeud $(N_1)$;

une source de courant $(I_S)$ ou une résistance connectée entre le noeud (N₁) et les seconds moyens d'alimentation (V$_{EE}$);

un étage de diode (D₀) connecté avec une orientation correspondant à une polarisation en inverse entre les moyens d'alimentation d'écriture (V$_p$) et les premiers moyens d'alimentation (V$_{CC}$);

une cellule de mémoire PROM du type à jonction court-circuitée (PC), connectée entre les moyens d'alimentation d'écriture (V$_p$) et le noeud (N₁); et

un élément de commutation (Q₁), connecté entre le noeud (N₁) et les seconds moyens d'alimentation (V$_{EE}$), pour recevoir un signal d'adresse à un bit;

pour générer ainsi un potentiel haut ou bas sur le noeud (N₁), conformément à l'état court-circuité ou non court-circuité de la cellule de mémoire PROM (PC).

14. Un dispositif de mémoire d'information comprenant :

des premiers moyens d'alimentation (V$_{CC}$);
des seconds moyens d'alimentation (V$_{EE}$);
des moyens d'alimentation d'écriture (V$_p$);
un noeud (N₁);

au moins deux étages de diode (D₁, D₂) connectés avec une orientation correspondant à une polarisation en direct entre les premiers moyens d'alimentation (V$_{CC}$) et le noeud (N₁);

une source de courant (I$_S$) ou une résistance connectée entre le noeud (N₁) et les seconds moyens d'alimentation (V$_{EE}$);

une résistance (R₀) connectée entre les moyens d'alimentation d'écriture (V$_p$) et les premiers moyens d'alimentation( V$_{CC}$);

une cellule de mémoire PROM du type à jonction court-circuitée (PC), connectée entre les moyens d'alimentation d'écriture (V$_p$) et le noeud (N₁); et

un élément de commutation( Q₁), connecté entre le noeud (N₁) et les seconds moyens d'alimentation (V$_{EE}$), pour recevoir un signal d'adresse à un bit,

pour générer ainsi un potentiel haut ou bas sur le noeud (N₁), conformément à l'état court-circuité ou non court-circuité de la cellule de mémoire PROM (PC).

15. Un dispositif de mémoire d'information comprenant :

des premiers moyens d'alimentation (V$_{CC}$);
des seconds moyens d'alimentation (V$_{EE}$);
des premiers moyens d'alimentation d'écriture (V$_p$);
des premier et second noeuds (N₀, N₁);
un étage de diode (D₀) connecté avec une orientation correspondant à une polarisation en direct entre les premiers moyens d'alimentation (V$_{CC}$) et le premier noeud (N₀);

au moins deux étages de diode (D₁, D₂) connectés avec une orientation correspondant à une polarisation en direct entre le premier noeud (N₀) et le second noeud (N₁);

une source de courant (I$_S$) ou une résistance connectée entre le second noeud (N₁) et les seconds moyens d'alimentation (V$_{EE}$);

une liaison directe entre les moyens d'alimentation d'écriture (V$_p$) et le premier noeud (N₀);

une cellule de mémoire PROM du type à jonction court-circuitée (PC) connectée entre les moyens d'alimentation d'écriture (V$_p$) et le second noeud (N₁); et

un élément de commutation (Q₁), connecté entre le second noeud (N₁) et les seconds moyens d'alimentation (V$_{EE}$), pour recevoir un signal d'adresse à un bit;

pour générer ainsi un potentiel haut ou bas sur le noeud (N₁), conformément à l'état court-circuit ou non court-circuité de la cellule de mémoire PROM (PC).

16. Un dispositif de mémoire d'information comprenant :

des premiers moyens d'alimentation (V$_{CC}$);
des seconds moyens d'alimentation (V$_{EE}$);
des moyens d'alimentation d'écriture (V$_p$);
des premier et second noeuds (N₁, N₂);

au moins trois étages de diode (D₁ à D₃) connectés avec une orientation correspondant à une polarisation en direct entre les premiers moyens d'alimentation (V$_{CC}$) et le premier noeud (N₁);

une première résistance (R₁) connectée entre le premier noeud (N₁) et les seconds moyens d'alimentation (V$_{EE}$);

un étage de diode (D₄) connecté entre les premier et second noeuds (N₁, N₂), et ayant le même sens de conduction que les trois étages, ou plus, de diode (D₁ à D₃);

une seconde résistance (R₂) connectée entre le second noeud (N₂) et les seconds moyens d'alimentation (V$_{EE}$);

un étage de diode (D₀) connecté avec une orientation correspondant à une polarisation en direct entre les premiers moyens d'alimentation (V$_{CC}$) et les moyens d'alimentation d'écriture (V$_p$);

une cellule de mémoire PROM du type à jonction court-circuitée (PC) connectée entre les moyens d'alimentation d'écriture (V$_p$) et le second noeud (N₂);

un élément de commutation (Q₁), connecté entre le second noeud (N₂) et les seconds moyens d'alimentation ($V_{EE}$), pour recevoir un signal d'adresse à un bit; et

des moyens de sortie ($Q_2$ à $Q_4$, $R_3$), connectés aux premier et second noeuds ($N_1$, $N_2$), pour détecter la différence de potentiel qui correspond à l'état court-circuité ou non court-circuité de la cellule de mémoire PROM (PC).

17. Un dispositif de mémoire d'information comprenant :

des premiers moyens d'alimentation ($V_{CC}$);
des seconds moyens d'alimentation ($V_{EE}$);
des moyens d'alimentation d'écriture ($V_p$);
des premier et second noeuds ($N_1$, $N_2$);
au moins trois étages de diode ($D_1$ à $D_3$) connectés avec une orientation correspondant à une polarisation en direct entre les premiers moyens d'alimentation ($V_{CC}$) et le premier noeud ($N_1$);

une première résistance ($R_1$) connectée entre le premier noeud ($N_1$) et les seconds moyens d'alimentation ($V_{EE}$);

au moins quatre étages de diode ($D'_1$ à $D'_3$, $D_4$), connectés avec une orientation correspondant à une polarisation en direct entre les premiers moyens d'alimentation ($V_{CC}$) et le second noeud ($N_2$);

une seconde résistance ($R_2$) connectée entre le second noeud ($N_2$) et les seconds moyens d'alimentation ($V_{EE}$);

un étage de diode ($D_0$) connecté avec une orientation correspondant à une polarisation en direct entre les premiers moyens d'alimentation ($V_{CC}$) et les moyens d'alimentation d'écriture ($V_p$);

une cellule de mémoire PROM du type à jonction court-circuitée (PC) connectée entre les moyens d'alimentation d'écriture ($V_p$) et le second noeud ($N_2$);

un élément de commutation ($Q_1$), connecté entre le second noeud ($N_2$) et les seconds moyens d'alimentation ($V_{EE}$), pour recevoir un signal d'adresse à un bit; et

des moyens de sortie ($Q_2$ à $Q_4$, $R_3$), connectés aux premier et second noeuds ($N_1$, $N_2$), pour détecter la différence de potentiel qui correspond à l'état court-circuité ou non court-circuité de la cellule de mémoire PROM (PC).

18. Un dispositif de mémoire d'information comprenant :

des premiers moyens d'alimentation ($V_{CC}$);
des seconds moyens d'alimentation ($V_{EE}$);
des moyens d'alimentation d'écriture ($V_p$);
des premier et second noeuds ($N_1$, $N_2$);
au moins deux étages de diode ($D_1$, $D_2$), connectés avec une orientation correspondant à une polarisation en direct entre les premiers moyens d'alimentation ($V_{CC}$) et le premier noeud ($N_1$);

une première résistance ($R_1$) connectée entre le premier noeud ($N_1$) et les seconds moyens d'alimentation ($V_{EE}$);

un étage de diode ($D_4$) connecté entre les premier et second noeuds ($N_1$, $N_2$), et ayant le même sens de conduction que les deux étages, ou plus, de diode ($D_1$, $D_2$);

une seconde résistance ($R_2$) connectée entre le second noeud ($N_2$) et les seconds moyens d'alimentation ($V_{EE}$);

une résistance ($R_0$) connectée entre les premiers moyens d'alimentation ($V_{CC}$) et les moyens d'alimentation d'écriture ($V_p$);

une cellule de mémoire PROM du type à jonction court-circuitée (PC) connectée entre les moyens d'alimentation d'écriture ($V_p$) et le second noeud ($N_2$);

un élément de commutation ($Q_1$), connecté entre le second noeud ($N_2$) et les seconds moyens d'alimentation ($V_{EE}$), pour recevoir un signal d'adresse à un bit: et

des moyens de sortie ($Q_2$ à $Q_4$, $R_3$), connectés aux premier et second noeuds ($N_1$, $N_2$), pour détecter la différence de potentiel qui correspond à l'état court-circuité ou non court-circuité de la cellule de mémoire PROM (PC).

19. Un dispositif de mémoire d'information comprenant :

des premiers moyens d'alimentation ($V_{CC}$);
des seconds moyens d'alimentation ($V_{EE}$);
des moyens d'alimentation d'écriture ($V_p$);
des premier, second et troisième noeuds ($N_0$, $N_1$, $N_2$);
un étage de diode ($D_0$) connecté avec une orientation correspondant à une polarisation en direct entre les premiers moyens d'alimentation ($V_{CC}$) et le premier noeud ($N_0$);

au moins deux étages de diode ($D_1$, $D_2$) connectés avec une orientation correspondant à une polarisation en direct entre les premier et second noeuds ($N_0$, $N_1$);

une première résistance ($R_1$) connectée entre le second noeud ($N_1$) et les seconds moyens d'alimentation ($V_{EE}$);

un étage de diode ($D_4$) connecté entre les premier et second noeuds ($N_1$, $N_2$), et ayant le même sens de conduction que les deux étages, ou plus, de diode ($D_1$, $D_2$);

une seconde résistance ($R_2$) connectée entre le second noeud ($N_2$) et les seconds moyens d'alimentation ($V_{EE}$);

une liaison directe entre le premier noeud ($N_0$) et les moyens d'alimentation d'écriture ($V_p$);

une cellule de mémoire PROM du type à jonction court-circuitée (PC), connectée entre les moyens d'alimentation d'écriture ($V_p$) et le troisième noeud ($N_2$);

un élément de commutation ($Q_1$), connecté, entre le troisième noeud ($N_2$) et les seconds moyens d'alimentation ($V_{EE}$), pour recevoir un signal d'adresse à un bit; et

des moyens de sortie ($Q_2$ à $Q_4$, $R_3$), connectés aux second et troisième noeuds ($N_1$, $N_2$), pour détecter la différence de potentiel qui correspond à l'état court-circuité ou non court-circuité de la cellule de mémoire PROM (PC).

20. Un dispositif de mémoire d'information comprenant :

des premiers moyens d'alimentation ($V_{CC}$);
des seconds moyens d'alimentation ($V_{EE}$);
des moyens d'alimentation d'écriture ($V_p$);
des premier et second noeuds ($N_1$, $N_2$);
au moins deux étages de diode ($D_1$, $D_2$), connectés avec une orientation correspondant à une polarisation en direct entre les premiers moyens d'alimentation ($V_{CC}$) et le premier noeud ($N_1$);

une première résistance ($R_1$) connectée entre le premier noeud ($N_1$) et les seconds moyens d'alimentation ($V_{EE}$);

au moins trois étages de diode ($D'_1$, $D'_2$, $D_4$) connectés avec une orientation correspondant à une polarisation en direct entre les premiers moyens d'alimentation ($V_{CC}$) et le second noeud ($N_2$);

une seconde résistance ($R_2$) connectée entre le second noeud ($N_2$) et les seconds moyens d'alimentation ($V_{EE}$);

une résistance ($R_3$) connectée entre les premiers moyens d'alimentation ($V_{CC}$) et les moyens d'alimentation d'écriture ($V_p$); et

une cellule de mémoire PROM du type à jonction court-circuitée, connectée entre les moyens d'alimentation d'écriture ($V_p$) et le second noeud ($N_2$);

un élément de commutation ($Q_1$) connecté entre le second noeud ($N_2$) et les seconds moyens d'alimentation ($V_{EE}$), pour recevoir un signal d'adresse à un bit; et

des moyens de sortie ($Q_2$ à $Q_4$, $R_3$), connectés aux premier et second noeuds ($N_1$, $N_2$), pour détecter la différence de potentiel qui correspond à l'état court-circuité ou non court-circuité de la cellule de mémoire PROM (PC).

**Patentansprüche**

1. Eine Halbleiter-Speichervorrichtung eines bipolaren Transistortypen mit;

einer Speicherzellenanordnung (1);

einer Redundanzspeicherzellenanordnung (2),

Einrichtungen zum Empfangen eines Adressensignals ($A_0 \sim A_7$);

Einrichtungen (3, 4, 5) zum Selektieren einer normalen Speicherzelle aus der Speicherzellenanordnung, entsprechend dem Adressensignal ($A_0 \sim A_7$) von der Adressenempfangseinrichtung; und

Einrichtungen (7) zum Vergleichen der Adresse des Adressensignals ($A_0 \sim A_7$) von der Adressenempfangseinrichtung mit der fehlerhaften Adresse ($A_{0R} \sim A_{7R}$) einer fehlerhaften Speicherzelle der Speicherzellenanordnung (1), um die normalen Speicherzellenselektiereinrichtungen (3, 4, 5) abzuschalten und die Redundanzspeicherzellenanordnung (2) zu selektieren, wenn sich die Adresse des Adressensignals ($A_0 \sim A_7$) von der fehlerhaften Adresse ($A_{0R} \sim A_{7R}$) unterscheidet;

gekennzeichnet durch Einrichtungen (6) zum Speichern der fehlerhaften Adresse und enthaltend eine Vielzahl von 1-Bit-Speicherschaltungen (6-0, 6-1, ..., 6-7) eines Diodentyps, wobei jede Schaltung jedem Bit der fehlerhaften Adresse ($A_{0R} \sim A_{7R}$) entspricht.

2. Eine Vorrichtung nach Anpruch 1, worin jede der 1-Bit Speicherschaltungen (6-0~6-7) umfaßt;

eine erste Stromversorgungseinrichtung ($V_{CC}$);

eine zweite Stromversorgungseinrichtung ($V_{EE}$);

eine Schreibstromversorgungseinrichtung ($V_P$);

einen Knoten ($N_1$);

mindestens drei Diodenstufen ($D_1$ $D_3$), die entlang einer Vorwärtsdurchlaßrichtung zwischen der ersten Stromversorgungseinrichtung ($V_{CC}$) und dem Knoten ($N_1$) verbunden sind;

eine Stromquelle ($I_S$) oder einen Widerstand zwischen dem Knoten ($N_1$) und der zweiten Stromversorgungseinrichtung ($V_{EE}$) verbunden;

eine Diodenstufe ($D_0$), die entlang einer Rückwärtsdurchlaßrichtung zwischen der Schreibstromversorgungseinrichtung ($V_P$) und der ersten Stromversorgungseinrichtung ($V_{CC}$) verbunden ist;

eine kurzgeschlossene PROM-Zelle (PC) des Übergangstyps, die zwischen der Schreibstromversorgungseinrichtung ($V_P$) und dem Knoten ($N_1$) verbunden ist; und

ein Schaltelement ($Q_1$), das zwischen dem Knoten ($N_1$) und der zweiten Stromversorgungseinrichtung ($V_{EE}$) verbunden ist, zum Empfangen eines Bit des Adressensignals

$(A_0 \sim A_7)$,

wodurch ein hohes oder niedriges Potential von den Knoten $(N_1)$ erzeugt wird, entprechend dem kurzgeschlossenen oder nicht-kurzgeschlossenen Status der PROM-Zelle $(PC)$.

3. Eine Vorrichtung nach Anspruch 1, worin jede der 1-Bit Speicherschaltungen $(6\text{-}0 \sim 6\text{-}7)$ umfaßt;

eine erste Stromversorgungseinrichtung $(V_{CC})$;

eine zweite Stromversorgungseinrichtung $(V_{EE})$;

eine Schreibstromversorgungseinrichtung $(V_{EE})$;

einen Knoten $(N_1)$;

mindestens zwei Diodenstufen $(D_1, D_2)$, die entlang einer Vorwärtsdurchlaßrichtung zwischen der ersten Stromversorgungseinrichtung $(V_{CC})$ und dem Knoten $(N_1)$ verbunden sind;

eine Stromquelle $(I_S)$ oder einen Widerstand zwischen dem Knoten $(N_1)$ und der zweiten Stromversorgungseinrichtung $(V_{EE})$ verbunden;

einen Widerstand $(R_0)$, zwischen der Schreibstromversorgungseinrichtung $(V_P)$ und der ersten Stromversorgungseinrichtung $(V_{CC})$ verbunden;

eine kurzgeschlossene PROM-Zelle des Übergangstyps $(PC)$, die zwischen der Schreibstromversorgungseinrichtung $(V_P)$ und dem Knoten $(N_1)$ verbunden ist; und

ein Schaltelement $(Q_1)$, zwischen dem Knoten $(N_1)$ und der zweiten Stromversorgungseinrichtung $(V_{EE})$ verbunden, zum Empfangen eines Bit des Adressensignals $(A_0 \sim A_7)$,

wodurch ein hohes oder niedriges Potential von dem Knoten $(N_1)$ erzeugt wird, entsprechend dem kurzgeschlossenen oder nicht-kurzgeschlosenen Status der PROM-Zelle $(PC)$.

4. Eine Vorrichtung nach Anspruch 1, worin jede der 1-Bit-Speicherschaltungen $(6\text{-}0 \sim 6\text{-}7)$ umfaßt;

eine erste Stromversorgungeinrichtung $(V_{CC})$;

eine zweite Stromversorgungseinrichtung $(V_{EE})$;

eine Schreibstromversorgungseinrichtung $(V_P)$;

ersten und zweiten Knoten $(N_0, N_1)$;

eine Diodenstufe $(D_0)$, die entlang einer Vorwärtsdurchlaßrichtung zwischen der ersten Stromversorgungseinrichtung $(V_{CC})$ und dem ersten Knoten $(N_0)$ verbunden ist;

mindestens zwei Diodenstufen $(D_1, D_2)$, die entlang einer Vorwärtsdurchlaßrichtung zwischen dem ersten Knoten $(N_0)$ und dem zweiten Knoten $(N_1)$ verbunden sind;

einer Stromquelle $(I_S)$ oder einem Widerstand, zwischen dem zweiten Knoten $(N_1)$ und der zweiten Stromversorgungseinrichtung $(V_{EE})$ verbunden;

einer direkten Verbindung zwischen der Schreibstromversorgungseinrichtung $(V_P)$ und dem ersten Knoten $(N_0)$;

eine kurzgeschlossene PROM-Zelle des Überganstypus $(PC)$, die zwischen der Schreibstromversorgungseinrichtung $(V_P)$ und dem zweiten Knoten $(N_1)$ verbunden ist; und

ein Schaltelement $(Q_1)$, das zwischen dem zweiten Knoten $(N_1)$ und der zweiten Stromverzorgungseinrichtung $(V_{EE})$ verbunden ist, zum Empfangen eines Bit des Adressensignals $(A_0 \sim A_7)$,

wodurch ein hohes oder niedriges Potential von dem Knoten $(N_1)$ erzeugt wird, entsprechend dem kurzgeschlossenen oder nicht-kurzgeschlossenen Status der PROM-Zelle $(PC)$.

5. Eine Vorrichtung nach Anspruch 1, worin jede der 1-Bit-Speicherschaltungen $(6\text{-}0 \sim 6\text{-}7)$ umfaßt;

eine erste Stromversorgungeinrichtung $(V_{CC})$;

eine zweite Stromversorgungseinrichtung $(V_{EE})$;

eine Schreibstromversorgungseinrichtung $(V_P)$;

ersten und zeiten Knoten $(N_1, N_2)$;

mindestens drei Diodenstufen $(D_1 \sim D_3)$ entlang einer Vorwärtsdurchlaßrichtung zwischen der ersten Stromversorgungeinrichtung $(V_{CC})$ und dem ersten Knoten $(N_1)$;

einen ersten Widerstand $(R_1)$, der zwischen dem ersten Knoten $(N_1)$ und der zweiten Stromversorgungseinrichtung $(V_{EE})$ verbunden ist;

eine Diodenstufe $(D_4)$, die zwischen dem ersten und dem zweiten Knoten $(N_1, N_2)$ verbunden ist und die gleiche Leitungsrichtung hat, wie die mindestens drei Diodenstufen $(D_1 \sim D_3)$;

einen zweiten Widerstand $(R_2)$, der zwischen dem zweiten Knoten $(N_2)$ und der zweiten Stromversorgungseinrichtung $(V_{EE})$ verbunden ist;

eine Diodenstufe $(D_0)$, die entlang einer Vorwärtsdurchlaßrichtung zwischen der ersten Stromversorgunseinrichtung $(V_{CC})$ und der Schreibstromversorgungseinrichtung $(V_P)$ verbunden ist;

eine kurzgeschlossene PROM-Zelle (PC) des Übergangstyps, die zwischen der Schreibstromversorgungseinrichtung ($V_P$) und dem zweiten Knoten ($N_2$) verbunden ist;

ein Schaltelement ($Q_1$), das zwischen dem zweiten Knoten ($N_2$) und der zweiten Stromversorgungseinrichtung ($V_{EE}$) verbunden ist, zum Empfangen eines Bits des Adressensignals ($A_0 \sim A_7$); und

Ausgabeeinrichtungen ($Q_2 \sim Q_4$, $R_3$), die mit dem ersten und den zweiten Knoten ($N_1$, $N_2$) verbunden sind, zum Erkennen der Potentialdifferenz entsprechend dem kurzgeschlossenen oder nicht-kurzgeschlossenen Status der PROM-Zelle (PC).

6. Eine Vorrichtung nach Anspruch 1, worin jede der 1-Bit-Speicherschaltungen (6-0~6-7) umfaßt;

eine erste Stromversorgungseinrichtung ($V_{CC}$);

eine zweite Stromversorgungseinrichtung ($V_{EE}$);

eine Schreibstromversorgungseinrichtung ($V_P$);

erste und zweite Knoten ($N_1$, $N_2$);

mindestens drei Diodenstufen ($D_1 \sim D_3$) entlang einer Vorwärtsdurchlaßrichtung zwischen der ersten Stromversorgunseinrichtung ($V_{CC}$) und dem ersten Knoten ($N_1$);

einen ersten Widerstand ($R_1$), der zwischen dem ersten Knoten ($N_1$) und der zweiten Stromversorgungseinrichtung ($V_{EE}$) verbunden ist;

mindestens vier Diodenstufen ($D_1' \sim D3'$, $D_4$), die entlang einer Vorwärtsdurchlaßrichtung zwischen der ersten Stromversorgungseinrichtung ($V_{CC}$) und dem zweiten Knoten ($N_2$) verbunden sind;

einen zweiten Widerstand ($R_2$), der zwischen dem zweiten Knoten ($N_2$) und der zweiten Stromversorgungseinrichtung ($V_{EE}$) verbunden ist;

eine Diodenstufe ($D_0$), die entlang einer Vorwärtsdurchlaßrichtung zwischen der ersten Stromversorgungeinrichtung ($V_{CC}$) und der Schreibstromversorgungseinrichtung ($V_P$) verbunden ist; und

eine Kurzgeschlossene PROM-Zelle des Übergangstyps (PC), die zwischen der Schreibstromversorgungseinrichtung ($V_P$) und dem zweiten Knoten ($N_2$) verbunden ist;

ein Schaltelement ($Q_1$), das zwischen dem zweiten Knoten ($N_2$) und der zweiten Stromversorgunseinrichtung ($V_{EE}$) verbunden ist, zum Empfangen eines Bit des Adressensignals ($A_0 \sim A_7$); und

Ausgabeeinrichtungen ($Q_2 \sim Q_4$, $R_3$), die an den ersten und den zweiten Knoten ($N_1$, $N_2$) angeschlossen sind, zum Erkennen der Potentialdifferenz entsprechend dem kurzgeschlossenen oder nicht-kurzgeschlossenen Status der PROM-Zelle (PC).

7. Eine Vorrichtung nach Anspruch 1, worin jede der 1-Bit-Speicherschaltungen (6-0~6-7) enthält;

eine erste Stromversorgungseinrichtung ($V_{CC}$);

eine zweite Stromversorgungseinrichtung ($V_{EE}$);

eine Schreibstromversorgungseinrichtung ($V_P$);

erste und zweite Knoten ($N_1$, $N_2$);

mindestens zwei Diodenstufen ($D_1$, $D_2$) entlang einer Vorwärtsdurchlaßrichtung zwischen der ersten Stromversorgungseinrichtung ($V_{CC}$) und dem ersten Knoten ($N_1$);

einen ersten Widerstand ($R_1$), der zwischen dem ersten Knoten ($N_1$) und der zweiten Stromversorgungseinrichtung ($V_{EE}$) verbunden ist;

eine Diodenstufe ($D_4$), die zwischen dem ersten und dem zweiten Knoten ($N_1$, $N_2$) verbunden ist und die die gleiche Leitungsrichtung hat, wie die genannten mindestens zwei Diodenstufen ($D_1$, $D_2$);

einen zweiten Widerstand ($R_2$), der zwischen dem zweiten Knoten ($N_2$) und der zweiten Stromversorgungseinrichtung ($V_{EE}$) verbunden ist;

einen Widerstand ($R_0$), der zwischen der ersten Stromversorgungseinrichtung ($V_{CC}$) und der Schreibstromversorgungseinrichtung ($V_P$) verbunden ist;

eine kurzgeschlossene PROM-Zelle des Übergangstyps (PC), die zwischen der Schreibstromversorgungseinrichtung ($V_P$) und dem zweiten Knoten ($N_2$) verbunden ist;

ein Schaltelement ($Q_1$), das zwischen dem zweiten Knoten ($N_2$) und der zweiten Stromversorgungseinrichtung ($V_{EE}$) verbunden ist, zum Empfangen eines Bits des Adressensignals ($A_0 \sim A_7$); und

Ausgabeeinrichtungen ($Q_2 \sim Q_4$, $R_3$), die mit dem ersten und dem zweiten Knoten ($N_1$, $N_2$) verbunden sind, zum Erkennen der Potentialdifferenz entsprechend dem kurzgeschlossenen oder nicht-kurzgeschlossenen Status der PROM-Zelle (PC).

8. Eine Vorrichtung nach Anspruch 1, worin jede der 1-Bit-Speicherschaltungen (6-0~6-7) umfaßt;

eine erste Stromversorgungseinrichtung ($V_{CC}$);

eine zweite Stromversorgungeinrichtung ($V_{EE}$);

eine Schreibstromversorgungseinrichtung ($V_P$);

erste, zweite und dritte Knoten ($N_0$, $N_1$, $N_2$);

eine Diodenstufe ($D_0$), die entlang einer Vorwärtsdurchlaßrichtung zwischen der ersten Stromversorgungseinrichtung ($V_{CC}$) und dem ersten Knoten ($N_0$) verbunden ist;

mindestens zwei Diodenstufen ($D_1$, $D_2$) entlang einer Vorwärtsdurchlaßrichtung zwischen dem ersten und dem zweiten Knoten ($N_0$, $N_1$);

einen ersten Widerstand ($R_1$), der zwischen dem zweiten Knoten ($N_1$) und der zweiten Stromversorgungseinrichtung ($V_{EE}$) verbunden ist;

eine Diodenstufe ($D_4$), die zwischen dem ersten und dem zweiten Knoten ($N_1$, $N_2$) verbunden ist und die gleiche Leitungsrichtung hat, wie die genannten mindestens zwei Diodenstufen ($D_1$, $D_2$);

eine direkte Verbindung zwischen dem ersten Knoten ($N_0$) und der Schreibstromversorgungseinrichtung ($V_P$);

einen zweiten Wiederstand ($R_2$), der zwischen dem zweiten Knoten ($N_2$) und der zweiten Stromversorgungseinrichtung ($V_{EE}$) verbunden ist;

eine kurzgeschlossene PROM-Zelle des Übergangstyps ($PC$), die zwischen der Schreibstromversorgungseinrichtung ($V_P$) und dem dritten Knoten ($N_3$) verbunden ist;

ein Schaltelement ($Q_1$), das zwischen dem dritten Knoten ($N_2$) und der zweiten Stromversorgungseinrichtung ($V_{EE}$) verbunden ist, zum Empfangen eines Bits von dem Adressensignal ($A_0 \sim A_7$); und

Ausgabeeinrichtungen ($Q_2 \sim Q_4$, $R_3$), die mit dem zweiten und dritten Knoten ($N_1$, $N_2$) verbunden sind, zum Erkennen der Potentialdifferenz entsprechend dem kurzgeschlossenen oder nicht-kurzgeschlossenen Status der PROM-Zelle ($PC$).

9. Eine Vorrichtung nach Anspruch 1, worin jede der 1-Bit-Speicherschaltungen (6-0~6-7) umfaßt;

eine erste Stromversorgungseinrichtung ($V_{CC}$);

eine zweite Stromversorgungseinrichtung ($V_{EE}$);

eine Schreibstromversorgungseinrichtung ($V_P$);

erste und zweite Knoten ($N_1$, $N_2$);

mindestens zwei Diodenstufen ($D_1$, $D_2$) entlang einer Vorwärtsdurchlaßrichtung zwi-

schen der ersten Stromversorgungseinrichtung ($V_{CC}$) und dem ersten Knoten ($N_1$);

einen ersten Widerstand ($R_1$), der zwischen dem ersten Knoten ($N_1$) und der zweiten Stromversorgungseinrichtung ($V_{EE}$) verbunden ist;

mindestens drei Diodenstufen ($D_1'$, $D_2'$, $D_4$), die entlang einer Vorwärtsdurchlaßrichtung zwischen der ersten Stromversorgungseinrichtung ($V_{CC}$) und dem zweiten Knoten ($N_1$) verbunden sind;

einen zweiten Widerstand ($R_2$), der zwischen dem zweiten Knoten ($N_2$) und der zweiten Stromversorgungseinrichtung ($V_{EE}$) verbunden ist;

einen Widerstand ($R_3$), der zwischen der ersten Stromversorgungseinrichtung ($V_{CC}$) und der Schreibstromversorgungseinrichtung ($V_P$) verbunden ist;

eine kurzgeschlossene PROM-Zelle ($PC$) des Übergangstyps, die zwischen der Schreibstromversorgungseinrichtung ($V_P$) und dem zweiten Knoten ($N_2$) verbunden ist;

ein Schaltelement ($Q_1$), das zwischen dem zweiten Knoten ($N_2$) und der zweiten Stromversorgungseinrichtung ($V_{EE}$) verbunden ist, zum Empfangen eines Bits des Adressensignals ($A_0 \sim A_7$); und

Ausgabeeinrichtungen ($Q_2 \sim Q_4$, $R_3$), die mit dem ersten und den zweiten Knoten ($N_1$, $N_2$) verbunden sind, zum Erkennen dar Potentialdifferenz entsprechend dem kurzgeschlossenen oder nicht-kurzgeschlossenen Status der PROM-Zelle ($PC$).

10. Eine Vorrichtung nach Anspruch 1, die ferner Einrichtungen enthält, die zwischen der adressenempfangenden Einrichtung und der Speichereinrichtung der fehlerhaften Adresse verbunden sind, zum Übertragen des Adressensignals ($A_0 \sim A_7$) an die Speichereinrichtung der fehlerhaften Adresse während eines fehlerhaften Adressenschreibmodus, wobei eine Übertragung des Adressensignals ($A_0 \sim A_7$) an die Speichereinrichtung der fehlerhaften Adresse nicht zugelassen wird.

11. Eine Vorrichtung nach Anspruch 10, worin die Schalteinrichtung Pegelverschiebungseinrichtungen umfaßt, zum Verringern der Ausgabeamplitude der adressenempfangenden Einrichtung, so daß die Eingabeamplitude der Speichereinrichtung der fehlerhaften Adresse kleiner ist als die Ausgabeamplitude der Speichereinrichtung der fehlerhaften Adresse.

12. Eine Einrichtung nach Anspruch 11, worin die Pegelverschiebungseinrichtungen eine oder mehrere Stufen von Emitterfolgern, Dioden oder Widerständen umfassen.

**13.** Eine Informationsspeichervorrichtung mit:

einer ersten Stromversorgungseinrichtung ($V_{CC}$);

einer zweiten Stromversorgungseinrichtung (VEE);

einer Schreibstromversorgungseinrichtung ($V_P$);

einem Knoten ($N_1$);

mindestens drei Diodenstufen ($D_1 \sim D_3$), die entlang einer Vorwärtsdurchlaßrichtung zwischen der ersten Stromversorgungseinrichtung ($V_{CC}$) und dem Knoten ($N_1$) verbunden sind;

einer Stromquelle ($I_S$) oder einem Widerstand, zwischen dem Knoten ($N_1$) und der zweiten Stromversorgungseinrichtung ($V_{EE}$) verbunden;

einer Diodenstufe ($D_0$), die entlang einer Rückwärtsdurchlaßrichtung zwischen der Schreibstromversorgungseinrichtung ($V_P$) und der ersten Stromversorgungeinrichtung ($V_{CC}$) verbunden ist;

einer kurzgeschlossenen PROM-Zelle des Übergangstyps (PC), die zwischen der Schreibstromversorgungseinrichtung ($V_P$) und dem Knoten ($N_1$) verbunden ist; und

einem Schaltelement ($Q_1$), das zwischen dem Knoten (N1) und der zweiten Stromversorgungseinrichtung ($V_{EE}$) verbunden ist, zum Empfangen eines ein-Bit-Adressensignals,

wodurch ein hohes oder niedriges Potential von dem Knoten ($N_1$) erzeugt wird, entsprechend dem kurzgeschlossenen oder nicht-kurzgeschlossenen Status der PROM-Zelle (PC).

**14.** Eine Informationsspeichervorrichtung mit:

einer ersten Stromversorgungseinrichtung ($V_{CC}$);

einer zweiten Stromversorgungseinrichtung ($V_{EE}$);

einer Schreibstromversorgungseinrichtung ($V_P$),

einem Knoten ($N_1$);

mindestens zwei Diodenstufen ($D_1$, $D_2$), die entlang einer Vorwärtsdurchlaßrichtung zwischen der ersten Stromversorgungseinrichtung ($V_{CC}$) und dem Knoten ($N_1$) verbunden ist;

einer Stromquelle ($I_S$) oder einem Widerstand zwischen dem Knoten ($N_1$) und der zweiten Stromversorgungseinrichtung ($V_{EE}$) verbunden;

einem Widerstand ($R_0$), der zwischen der Schreibstromversorgungseinrichtung ($V_P$) und der ersten Stromversorgungeinrichtung ($V_{CC}$) verbunden ist;

einer kurzgeschlossenen PROM-Zelle des Übergangstyps (PC), die zwischen der Schreibversorgungseinrichtung ($V_P$) und dem Knoten ($N_1$) verbunden ist; und

einem Schaltelement ($Q_1$), dar zwischen dem Knoten ($N_1$) und der zweiten Stromversorgungseinrichtung ($V_{EE}$) verbunden ist, zum Empfangen eines ein-Bit-Adressensignals,

wodurch ein hohes oder niedriges Potential von dem Knoten ($N_1$) erzeugt wird, entsprechend dem kurzgeschlossenen oder nicht-kurzgeschlossenen Status der PROM-Zelle (PC).

**15.** Eine Informationsspeichervorrichtung mit:

einer ersten Stromversorgungseinrichtung ($V_{CC}$);

einer zweiten Stromversorgungseinrichtung ($V_{EE}$);

einer Schreibstromversorgungseinrichtung ($V_P$);

ersten und zweiten Knoten ($N_0$, $N_1$);

einer Diodenstufe ($D_0$), die entlang einer Vorwärtsdurchlaßrichtung zwischen der ersten Stromversorgungseinrichtung ($V_{CC}$) und dem ersten Knoten ($N_0$) verbunden ist;

mindestens zwei Diodenstufen ($D_1$, $D_2$), die entlang einer Vorwärtsdurchlaßrichtung zwischen dem ersten Knoten ($N_0$) und dem zweiten Knoten ($N_1$) verbunden sind;

einer Stromquelle ($I_S$) oder einem Widerstand, die oder der zwischen dem zweiten Knoten ($N_1$) und der zweiten Stromversorgungseinrichtung ($V_{EE}$) verbunden sind;

einer direkten Verbindung zwischen der Schreibstromversorgungseinrichtung ($V_P$) und dem ersten Knoten ($N_0$);

einer kurzgeschlossenen PROM-Zelle des Übergangstyps (PC), die zwischen der Schreibstromversorgungseinrichtung ($V_P$) und dem zweiten Knoten ($N_1$) verbunden ist; und

einem Schaltelement ($Q_1$), das zwischen dem zweiten Knoten ($N_1$) und der zweiten Stromversorgungseinrichtung ($V_{EE}$) verbunden ist, zum Empfangen eines ein-Bit-Adressensignals,

wodurch ein hohes oder niedriges Potential von dem Knoten ($N_1$) erzeugt wird, entsprechend dem kurzgeschlossenen oder nicht-kurzgeschlossenen Status der PROM-Zelle (PC).

**16.** Eine Informationsspeichervorrichtung mit:

einer ersten Stromversorgungseinrichtung ($V_{CC}$);

einer zweiten Stromversorgungseinrichtung ($V_{EE}$);

einer Schreibstromversorgungseinrichtung (V$_P$);

erstem und zweiten Knoten (N$_1$, N$_2$);

mindestens drei Diodenstufen (D$_1$~D$_3$), entlang einer Vorwärtsdurchlaßrichtung zwischen der ersten Stromversorgungseinrichtung (V$_{CC}$) und den ersten Knoten (N$_1$);

einem ersten Widerstand (R$_1$), der zwischen dem ersten Knoten (N$_1$) und der zweiten Stromversorgungseinrichtung (V$_{EE}$) verbunden ist,

einer Diodenstufe (D$_4$), die zwischen dem ersten und dem zweiten Knoten (N$_1$, N$_2$) verbunden ist und die gleiche Leitungsrichtung hat, wie die genannten mindestens drei Diodenstufen (D$_1$~D$_3$);

einem zweiten Widerstand (R$_2$), der zwischen dem zweiten Knoten (N$_2$) und der zweiten Stromversorgungseinrichtung (V$_{EE}$) verbunden ist;

einer Diodenstufe (D$_0$), die entlang einer Vorwärtsdurchlaßrichtung zwischen der ersten Stromversorgungseinrichtung (V$_{CC}$) und der Schreibstromversorgungseirichtung (V$_P$) verbunden ist;

einer kurzgeschlossenen PROM-Zelle des Übergangstyps (PC), die zwischen der Schreibstromversorgungseinrichtung (V$_P$) und dem zweiten Knoten (N$_2$) verbunden ist;

einem Schaltelement (Q$_1$), das zwischen dem zweiten Knoten (N$_2$) und der zweiten Stromversorgungseinrichtung (V$_{EE}$) verbunden ist, zum Empfangen eines ein-Bit Adressensignals; und

Ausgabeeinrichtungen (Q$_2$~Q$_4$, R$_3$), die mit dem ersten und zweiten Knoten (N$_1$, N$_2$) verbunden sind, zum Erkennen der Potentialdifferenz nach dem kurzgeschlossenen oder nicht-kurzgeschlossenen Status der PROM-Zelle (PC).

17. Eine Informationsspeichervorrichtung mit:

einer ersten Stromversorgungseinrichtung (V$_{CC}$);

einer zweiten Stromversorgungseinrichtung (V$_{EE}$);

einer Schreibstromversorgungseinrichtung (V$_P$);

erstem und zweiten Knoten (N$_1$, N$_2$);

mindestens drei Diodenstufen (D$_1$~D$_3$), entlang einer Vorwärtsdurchlaßrichtung zwischen der ersten Stromversorgungseinrichtung (V$_{CC}$) und dem ersten Knoten (N$_1$);

einem ersten Widerstand (R$_1$), der zwischen den ersten Knoten (N$_1$) und der zweiten Stromversorgungseinrichtung (V$_{EE}$) verbunden ist;

mindestens vier Diodenstufen (D$_1$'~D$_3$', D$_4$), die entlang einer Vorwärtsdurchlaßrichtung zwischen der ersten Stromversorgungeinrichtung (V$_{CC}$) und dem zweiten Knoten (N$_2$) verbunden sind;

einem zweiten Widerstand (R$_2$), der zwischen dem zweiten Knoten (N$_2$) und der zweiten Stromversorgungseinrichtung (V$_{EE}$) verbunden ist;

einer Diodenstufe (D$_0$), die entlang einer Vorwärtsdurchlaßrichtung zwischen der ersten Stromversorgungseinrichtung (V$_{CC}$) und der Schreibstromversorgungseinrichtung (V$_P$) verbunden ist;

einer kurzgeschlossenen PROM-Zelle (PC) des Übergangstyps, die zwischen der Schreibstromversorgungseinrichtung (V$_P$) und dem zweiten Knoten (N$_2$) verbunden ist;

einem Schaltelement (Q$_1$), das zwischen dem zweiten Knoten (N$_2$) und der zweiten Stromversorgungseinrichtung (V$_{EE}$) verbunden ist, zum Empfangen eines ein-Bit-Adressensignals; und

Ausgabeeinrichtungen (Q$_2$~Q$_4$, R$_3$), die mit dem ersten und dem zweiten Knoten (N$_1$, N$_2$) verbunden sind, zum Erkennen der Potentialdifferenz entsprechend dem kurzgeschlossenen oder nicht-kurzgeschlossenen Status der PROM-Zelle (PC).

18. Eine Informationsspeichervorrichtung mit:

einer ersten Stromversorgungseinrichtung (V$_{CC}$);

einer zweiten Stromversorgungseinrichtung (V$_{EE}$);

einer Schreibstromversorgungseinrichtung (V$_P$);

erstem und zweiten Knoten (N$_1$, N$_2$);

mindestens zwei Diodenstufen (D$_1$, D$_2$) entlang einer Vorwärtsdurchlaßrichtung zwischen der ersten Stromversorgungeinrichtung (V$_{CC}$) und dem ersten Knoten (N$_1$);

einem ersten Widerstand (R$_1$), der zwischen dem ersten Knoten (N$_1$) und der zweiten Stromversorgungeinrichtung (V$_{EE}$) verbunden ist;

einer Diodenstufe (D$_4$), die zwischen dem ersten und dem zweiten Knoten (N$_1$, N$_2$) verbunden ist, und die gleiche Leitungsrichtung hat, wie die genannten mindestens zwei Diodenstufen (D$_1$, D$_2$);

einem zweiten Widerstand (R$_2$), der zwischen dem zweiten Knoten (N$_2$) und der zweiten Stromversorgungseinrichtung (V$_{EE}$) verbunden ist;

einem Widerstand (R$_0$), der zwischen der ersten Stromversorgungeinrichtung (V$_{CC}$) und der Schreibstromversorgungseinrichtung (V$_P$) verbunden ist;

einer kurzgeschlossenen PROM-Zelle des Übergangstyps (PC), die zwischen der Schreibstromversorgungseinrichtung ($V_P$) und dem zweiten Knoten ($N_2$) verbunden ist;

einem Schaltelement ($Q_1$), das zwischen dem zweiten Knoten ($N_2$) und der zweiten Stromversorgungseinrichtung ($V_{EE}$) verbunden ist, zum Empfangen eines ein-Bit-Adressensignals; und

Ausgabeeinrichtungen ($Q_2 \sim Q_4$, $R_3$), die mit dem ersten und dem zweiten Knoten ($N_1$, $N_2$) verbunden sind, zum Erkennen der Potentialdifferenz entsprechend dem kurzgeschlossenen oder nicht-kurzgeschlossenen Status der PROM-Zelle (PC).

19. Eine Informationsspeichervorrichtung mit:

einer ersten Stromversorgungseinrichtung ($V_{CC}$);

einer zweiten Stromversorgungseinrichtung ($V_{EE}$);

einer Schreibstromversorgungseinrichtung ($V_P$);

ersten, zweiten und dritten Knoten ($N_0$, $N_1$, $N_2$);

einer Diodenstufe ($D_0$), die entlang einer Vorwärtsdurchlaßrichtung zwischen der ersten Stromversorgungseinrichtung ($V_{CC}$) und dem ersten Knoten ($N_0$) verbunden ist;

mindestens zwei Diodenstufen ($D_1$, $D_2$) entlang einer Vorwärtsdurchlaßrichtung zwischen dem ersten und dem zweiten Knoten ($N_0$, $N_1$);

einem ersten Widerstand ($R_1$), der zwischen dem zweiten Knoten ($N_1$) und der zweiten Stromversorgungseinrichtung ($V_{EE}$) verbunden ist;

einer Diodenstufe ($D_4$), die zwischen dem ersten und dem zweiten Knoten ($N_1$, $N_2$) verbunden ist und die gleiche Leitungsrichtung hat, wie die genannten mindestens zwei Diodenstufen ($D_1$, $D_2$);

einem zweiten Widerstand ($R_2$), der zwischen dem zweiten Knoten ($N_2$) und der zweiten Stromversorgungseinrichtung ($V_{EE}$) verbunden ist;

einer direkten Verbindung zwischen dem ersten Knoten ($N_0$) und der Schreibstromversorgungseinrichtung ($V_P$);

einer kurzgeschlossenen PROM-Zelle des Übergangstyps (PC), die zwischen der Schreibstromversorgungseinrichtung ($V_P$) und dem dritten Knoten ($N_2$) verbunden ist;

einem Schaltelement ($Q_1$), das zwischen dem dritten Knoten ($N_2$) und der zweiten Stromversorgungseinrichtung ($V_{EE}$) verbunden ist, zum Empfangen eines ein-Bit-Adressensignals; und

Ausgabeeinrichtungen ($Q_2 \sim Q_4$, $R_3$), die mit dem zweiten und den dritten Knoten ($N_1$, $N_2$) verbunden sind, zum Erkennen der Potentialdifferenz entsprechend dem kurzgeschlossenen oder nicht-kurzgeschlossenen Status der PROM-Zelle (PC).

20. Eine Informationsspeichervorrichtung mit:

einer ersten Stromversorgungseinrichtung ($V_{CC}$);

einer zweiten Stromversorgungseinrichtung ($V_{EE}$);

einer Schreibstromversorgungseinrichtung ($V_P$);

erstem und zweiten Knoten ($N_1$, $N_2$);

mindestens zwei Diodenstufen ($D_1$, $D_2$) entlang einer Vorwärtsdurchlaßrichtung zwischen der ersten Stromversorgungseinrichtung ($V_{CC}$) und dem ersten Knoten ($N_1$);

einem ersten Widerstand ($R_1$), der zwischen dem ersten Knoten ($N_1$) und der zweiten Stromversorgungseinrichtung ($V_{EE}$) verbunden ist;

mindestens drei Diodenstufen ($D_1'$, $D_2'$, $D_4$), die entlang einer Vorwärtsdurchlaßrichtung zwischen der ersten Stromversorgungseinrichtung ($V_{CC}$) und dem zweiten Knoten ($N_2$) verbunden sind;

einem zweiten Widerstand ($R_2$), der zwischen dem zweiten Knoten ($N_2$) und der ersten Stromversorgungseinrichtung ($V_{EE}$) verbunden ist;

einem Widerstand ($R_3$), der zwischen der ersten Stromversorgungseinrichtung ($V_{CC}$) und der Schreibstromversorgungseinrichtung ($V_P$) verbunden ist; und

einer kurzgeschlossenen PROM-Zelle des Übergangstyps (PC), die zwischen der Schreibstromversorgungseinheit ($V_P$) und dem zweiten Knoten ($N_2$) verbunden ist;

einem Schaltelement ($Q_1$), das zwischen dem zweiten Knoten ($N_2$) und der zweiten Stromversorgungseinrichtung ($V_{EE}$) verbunden ist, zum Empfangen eines ein-Bit-Adressensignals; und

Ausgabeeinrichtungen ($Q_2 \sim Q_4$, $R_3$), die mit dem ersten und der zweiten Knoten ($N_1$, $N_2$) verbunden sind, zum Erkennen der Potentialdifferenz entsprechend dem kurzgeschlossenen oder nicht-kurzgeschlossenen Status der PROM-Zelle (PC).

# Fig. 1

# Fig. 2

# Fig. 3

# Fig. 4

26

## Fig. 5

## Fig. 6

# Fig. 7

# Fig. 8

# Fig. 9

# Fig. 10

## Fig. 11A

Fig. 11

| Fig. 11A | Fig. 11B |
|---|---|

# Fig. IIB

Fig. 12A

Fig. 12

Fig. 12A

Fig. 12B

EP 0 178 948 B1

# Fig. 12B